# EUROPEAN PATENT APPLICATION

(11) **EP 4 492 937 A1**
(43) Date of publication of application: **15.01.2025**
(21) Application number: 24154996.3
(22) Date of filing: 31.01.2024
(51) Int. Cl.: H10B 12/00, H01L 21/033

(54) **SEMICONDUCTOR DEVICE AND METHOD OF FABRICATING THE SAME**

(30) Priority: 13.07.2023 KR 20230090902
(71) Applicant: Samsung Electronics Co., Ltd., Suwon-si, Gyeonggi-do 16677 (KR)
(72) Inventor: KIM, Eun Jung, 16677 Suwon-si, Gyeonggi-do (KR); KIM, Sung Woo, 16677 Suwon-si, Gyeonggi-do (KR); SHIN, Hyun Seo, 16677 Suwon-si, Gyeonggi-do (KR); CHO, Min Jeong, 16677 Suwon-si, Gyeonggi-do (KR); CHOI, Min Su, 16677 Suwon-si, Gyeonggi-do (KR)
(74) Representative: Kuhnen & Wacker Patent- und Rechtsanwaltsbüro PartG mbB

(57) **Abstract**

A method of fabricating a semiconductor device includes providing a substrate, forming a target film, a first mask film, a second mask film, and an upper mask pattern on the substrate, forming a first spacer pattern that includes a first line portion and a second line portion, and a folding portion that connects the first line portion and the second line portion, forming a slit mask pattern that partially covers the first spacer pattern, forming a first mask pattern by patterning the second mask film using the slit mask pattern and the first spacer pattern as an etching mask, forming a second spacer pattern, forming a second mask pattern by patterning the first mask film using the second spacer pattern as an etching mask, and forming a plurality of target patterns by patterning the target film using the second mask pattern as an etching mask.

## Description

### CROSS-REFERENCE TO RELATED APPLICATION

This application claims priority from Korean Patent Application No. 10-2023-0090902, filed on July 13, 2023 in the Korean Intellectual Property Office, the contents of which are herein incorporated by reference in their entirety.

### TECHNICAL FIELD

Embodiments of the present disclosure are directed to a semiconductor device and a method of fabricating the same, and more particularly, to a semiconductor memory device that includes line patterns and a method of fabricating the semiconductor device.

### DISCUSSION OF THE RELATED ART

As semiconductor devices become increasingly integrated, individual circuit patterns are becoming finer to implement more semiconductor devices within the same area. However, the miniaturization of individual circuit patterns increases the complexity of the manufacturing processes and can cause defects.

### SUMMARY

Embodiments of the present disclosure provide a method of fabricating a semiconductor device with enhanced process margins.

Embodiments of the present disclosure also provide a semiconductor device with an enhanced integration level.

According to an embodiment of the present disclosure, there is provided a method of fabricating a semiconductor device that includes providing a substrate that includes a first region and a second region, sequentially forming a target film, a first mask film, a second mask film, and an upper mask pattern on the substrate, forming a first spacer pattern that extends along a side surface of the upper mask pattern, wherein the first space pattern includes a first line portion and a second line portion that extend in parallel across the first region and the second region, and a folding portion that is bent from the first line portion and the second line portion on the second region and that connects the first line portion and the second line portion, forming a slit mask pattern that covers the first spacer pattern on the second region, forming a first mask pattern by patterning the second mask film using the slit mask pattern and the first spacer pattern as an etching mask, forming a second spacer pattern that extends along an inner side surface and an outer side surface of the first mask pattern, forming a second mask pattern by patterning the first mask film using the second spacer pattern as an etching mask, and forming a plurality of target patterns by patterning the target film using the second mask pattern as an etching mask.

According an embodiment, there is provided a method of fabricating a semiconductor device that includes providing a substrate, sequentially forming a target film, a first mask film, a second mask film, and an upper mask pattern on the substrate, forming a first spacer pattern that extends along a side surface of the upper mask pattern, forming a first mask pattern by patterning the second mask film using the first spacer pattern as an etching mask, forming a second spacer pattern that includes an inner spacer pattern that extends along an inner side surface of the first mask pattern and an outer spacer pattern that extends along an outer side surface of the first mask pattern, forming a second mask pattern by patterning the first mask film using the second spacer pattern as an etching mask, and forming a plurality of line patterns by patterning the target film using the second mask pattern as an etching mask. The inner spacer pattern includes a first inner line portion and a second inner line portion that extend in parallel, a first inner folding portion that connects a first end of the first inner line portion and a first end of the second inner line portion, and a second inner folding portion that connects a second end of the first inner line portion and a second end of the second inner line portion. The outer spacer pattern extends along a circumference of the first inner line portion, a circumference of the second inner line portion, and a circumference of the second inner folding portion, and does not extend along a circumference of the first inner folding portion.

According an embodiment, there is provided a semiconductor device that includes a substrate, a first conductive pattern disposed on the substrate, where the first conductive pattern includes a first line pattern and a second line pattern that extend in parallel in a first direction, and a first folding pattern that connects a first end of the first line pattern and a first end of the second line pattern, and a second conductive pattern disposed on the substrate, where the second conductive pattern includes a third line pattern and a fourth line pattern that extend in parallel in the first direction, and a second folding pattern that connects a first end of the third line pattern and a first end of the fourth line pattern. The second folding pattern protrudes beyond the first folding pattern in the first direction, and the first conductive pattern and the second conductive pattern are alternately and repeatedly arranged in a second direction that intersects with the first direction.

It should be noted that the effects of the present disclosure are not limited to those described above, and other effects of the present disclosure will be apparent from the following description.

### BRIEF DESCRIPTION OF THE DRAWINGS

FIG. 1 is a layout view of a semiconductor device according to some embodiments.
FIG. 2 is an enlarged layout view of a region R of FIG. 1.
FIG. 3 is a cross-sectional view taken along line I1-I1 of FIG. 2.
FIG. 4 is a cross-sectional view taken along line I2-I2 of FIG. 2.
FIGS. 5 and 6 are enlarged layout views of regions R (of FIG. 1) of semiconductor devices according to some embodiments.
FIGS. 7 through 32 illustrate intermediate steps of a method of fabricating a semiconductor device according to some embodiments.
FIG. 33 is a layout view that illustrates an intermediate step of a method of fabricating a semiconductor device according to some embodiments.
FIGS. 34 through 39 illustrate intermediate steps of a method of fabricating a semiconductor device according to some embodiments.
FIGS. 40 through 49 illustrate intermediate steps of a method of fabricating a semiconductor device according to some embodiments.
FIGS. 50 through 53 illustrate intermediate steps of a method of fabricating a semiconductor device according to some embodiments.

### DETAILED DESCRIPTION

In this specification, a dynamic random-access memory (DRAM) will be mainly described as an exemplary semiconductor device, but is merely illustrative. Those skilled in the art to which the present disclosure pertains will understand that embodiments of the inventive concept can be applied to various other semiconductor devices that include circuit patterns formed by patterning. For example, embodiments of the inventive concept can be applied to different semiconductor devices, such as system large scale integration (LSI), flash memories, static random-access memories (SRAMs), electrically erasable programmable read-only memories (EEPROMs), phase change random-access memories (PRAMs), magnetoresistive random-access memories (MRAMs), resistive random-access memories (RERAMs), complementary metal-oxide semiconductor (CMOS) imaging sensors (CISs), micro-electro-mechanical systems (MEMSs), active components, passive components, etc.

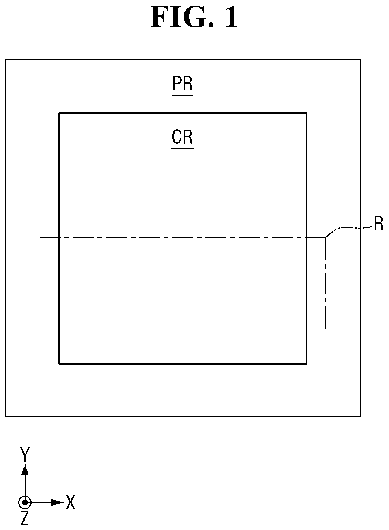

A semiconductor device according to some exemplary embodiments will hereinafter be described with reference to FIGS. 1 through 6.

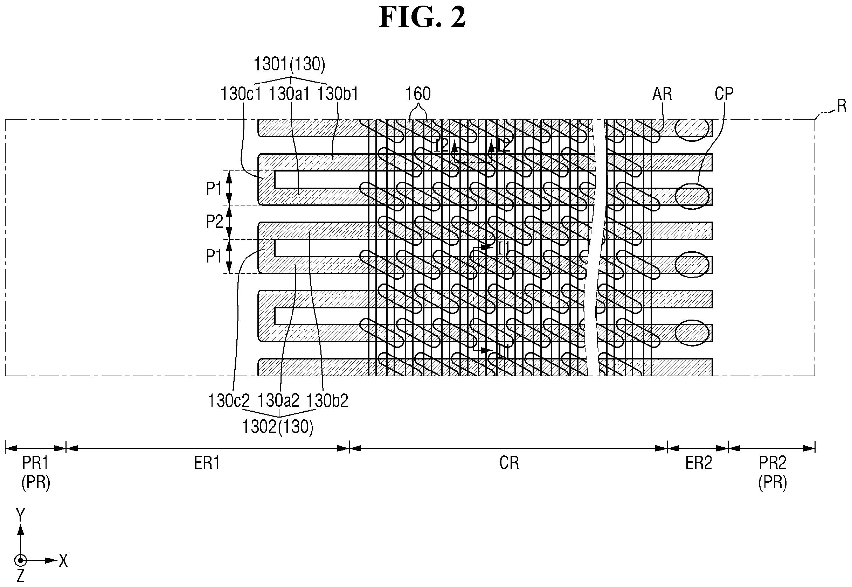

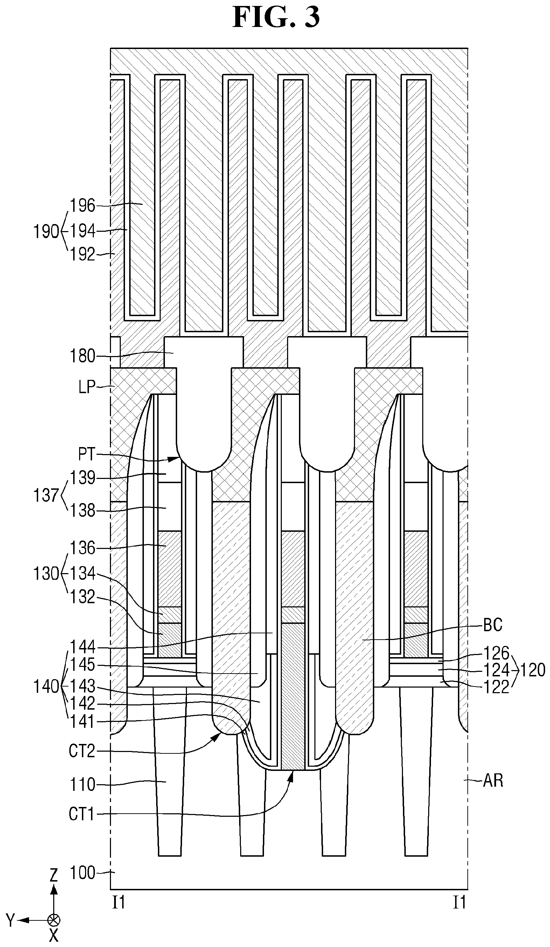

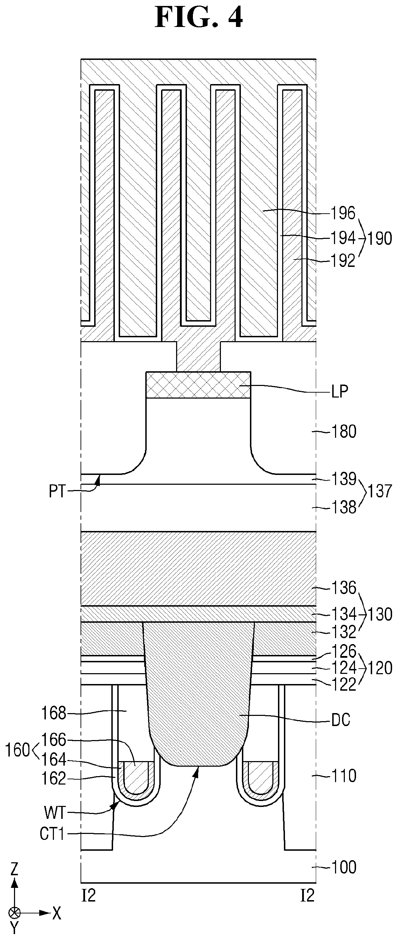

FIG. 1 is a layout view of a semiconductor device according to some embodiments. FIG. 2 is an enlarged layout view of a region R of FIG. 1. FIG. 3 is a cross-sectional view taken along line I1-I1 of FIG. 2. FIG. 4 is a cross-sectional view taken along line I2-I2 of FIG. 2.

Referring to FIGS. 1 and 2, a semiconductor device according to some embodiments includes a cell region CR, boundary regions ER1 and ER2, and a peripheral region PR.

Memory cells are disposed in the cell region CR. The peripheral region PR is a core/peri region formed around the cell region CR. In the peripheral region PR, some control components and dummy components are formed that control functions of the memory cells formed in the cell region CR. The peripheral region PR is illustrated as surrounding the cell region CR, but embodiments of the present disclosure are not necessarily limited thereto. For example, in other embodiments, the cell region CR and the peripheral region PR are arranged in various other configurations. In this specification, the cell region CR may also be referred to as a first region.

In some embodiments, the peripheral region PR includes first and second peripheral regions PR1 and PR2, and the first and second peripheral regions PR1 and PR2 are arranged around the cell region CR in a first direction X. The cell region CR is interposed between the first and second peripheral regions PR1 and PR2 in the first direction X.

The boundary regions ER1 and ER2 are interposed between the cell region CR and the peripheral region PR. For example, the boundary regions ER1 and ER2 include first and second boundary regions ER1 and ER2. The first boundary region ER1 is interposed between the cell region CR and the first peripheral region PR1, and the second boundary region ER2 is located between the cell region CR and the second peripheral region PR2. In this specification, the first boundary region ER1 may also be referred to as a second region.

Referring to FIGS. 1 through 4, the semiconductor device according to some embodiments include a substrate 100, device isolation patterns 110, a base insulating layer 120, conductive patterns 130, first capping patterns 137, gate electrodes 160, gate insulating layers 162, second capping patterns 168, direct contacts DC, spacer structures 140, buried contacts BC, landing pads LP, capacitor structures 190, and contact plugs CP.

The substrate 100 is a semiconductor substrate such as a silicon wafer. The substrate 100 may have a structure where a base substrate and an epitaxial layer are stacked, but embodiments of the present disclosure are not necessarily limited thereto. The substrate 100 is one of a silicon substrate, a gallium arsenide substrate, silicon-germanium substrate, or a semiconductor-on-insulator (SOI) substrate. For illustrative purposes, the substrate 100 will hereinafter be described as being a silicon substrate.

The substrate 100 includes active regions AR. The active regions AR are defined by the device isolation patterns 110 within the substrate 100. As the design rules for semiconductor devices decrease, the active regions AR are formed in a bar shape that extends diagonally. For example, as illustrated in FIG. 2, the active regions AR are bars that extend in a direction that differs from the first direction X and a second direction Y, on a plane that includes the first and second directions X and Y.

The active regions AR include multiple bar-shaped regions that extend parallel to one another. In some embodiments, the center of one of the active regions AR is adjacent to an end of another active region (AR).

The active regions AR serve as source/drain regions and contain impurities. For example, a first portion, such as the central part, of each of the active regions AR is connected to a conductive pattern 130 via a direct contact DC, while second portions, such as both end parts, of the corresponding active region AR are connected to capacitor structures 190 via buried contacts BC and/or landing pads LP.

The base insulating layer 120 is formed on the substrate 100 and the device isolation patterns 110. The base insulating layer 120 is interposed between the substrate 100 and the conductive patterns 130 or between the device isolation patterns 110 and the conductive patterns 130.

In an embodiment, the base insulating layer 120 is a single layer. In another embodiment, as illustrated in FIGS. 3 and 4, the base insulating layer 120 has a multilayer structure. For example, the base insulating layer 120 include first, second, and third insulating layers 122, 124 and 126 that are sequentially stacked on the substrate 100 and the device isolation patterns 110. For example, the first insulating layer 122 includes a silicon oxide layer, the second insulating layer 124 includes a silicon nitride layer, and the third insulating layer 126 includes a silicon oxide layer.

The conductive patterns 130 are formed on the substrate 100, the device isolation patterns 110, and the base insulating layer 120. The conductive patterns 130 intersect with the active regions AR and the gate electrodes 160. For example, the conductive patterns 130 extend longitudinally in the first direction X, diagonally crossing the active regions AR, and vertically intersecting with the gate electrodes 160. Multiple conductive patterns 130 are arranged along the second direction Y, which intersects the first direction X. The conductive patterns 130 may be bitlines.

The conductive patterns 130 have a "U" shape from a planar perspective. For example, the conductive patterns 130 include a plurality of line patterns 130a1, 130b1, 130a2, and 130b2 that extend in parallel, and a plurality of folding patterns 130c1 and 130c2 that connect the line patterns 130a1, 130b1, 130a2, and 130b2.

The line patterns 130a1, 130b1, 130a2, and 130b2 extend longitudinally in the first direction X across the cell region CR. For example, the line patterns 130a1, 130b1, 130a2, and 130b2 extend in the first direction X across the first boundary region ER1, the cell region CR, and the second boundary region ER2.

The folding patterns 130c1 and 130c2 may connect the line patterns 130a1, 130b1, 130a2, and 130b2 outside the cell region CR. For example, the folding patterns 130c1 and 130c2 are disposed in the first boundary region ER1.

For example, each of the conductive patterns 130 includes first and second conductive patterns 1301 and 1302 that are arranged along the second direction Y.

The first conductive pattern 1301 includes a first line pattern 130a1, a second line pattern 130b1, and a first folding pattern 130c1. The first and second line patterns 130a1 and 130b 1 extend longitudinally in the first direction X and are arranged along the second direction Y. The first folding pattern 130c1 connects first ends of the first and second line patterns 130a1 and 130b 1 in the first boundary region ER1. In some embodiments, second ends of the first and second line patterns 130a1 and 130b 1 are spaced apart from each other in the second direction Y. For example, the first and second line patterns 130a1 and 130b1 are not connected in the second boundary region ER2.

The second conductive pattern 1302 includes a third line pattern 130a2, a fourth line pattern 130b2, and a second folding pattern 130c2. The third and fourth line patterns 130a2 and 130b2 extend longitudinally in the first direction X and are arranged along the second direction Y. The second folding pattern 130c2 connects first ends of the third and fourth line patterns 130a2 and 130b2 in the first boundary region ER1. In some embodiments, second ends of the third and fourth line patterns 130a2 and 130b2 are spaced apart from each other in the second direction Y. For example, the third and fourth line patterns 130a2 and 130b2 are not connected in the second boundary region ER2.

In some embodiments, the folding patterns 130c1 and 130c2 are arranged in a row in the second direction Y. For example, the first and second folding patterns 130c1 and 130c2 lie on a straight line that extends in the second direction Y.

In some embodiments, the second ends of the line patterns 130a1, 130b 1, 130a2, and 130b2 are aligned in a row along the second direction Y. For example, the second ends of the first, second, third, and fourth line patterns 130a1, 130b1, 130a2, and 130b2 all lie on a straight line that extends in the second direction Y.

In some embodiments, the line patterns 130a1, 130b1, 130a2, and 130b2 extend longitudinally in the first direction X and are connected to multiple active regions AR arranged along the first direction X. For example, each of the line patterns 130a1, 130b 1, 130a2, 130b2 is connected to first portions, such as the central parts, of the active regions AR through multiple direct contacts DC arranged along the first direction X.

In some embodiments, pitches P1, P2 between the line patterns 130a1, 130b1, 130a2, and 130b2 are the same. Here, the term "same" includes not only completely identical but also slightly different due to process margins and other factors. For example, as illustrated in FIG. 2, a pitch P1 between the first and second line patterns 130a1 and 130b 1, or between the third and fourth third line patterns 130a2 and 130b2, is the same as a pitch P2 between the first and fourth line patterns 130a1 and 130b2.

In some embodiments, the pitches P1, P2 are approximately 10 nm or less. For example, the pitches P1, P2 range from about 4 nm to about 10 nm. The line patterns 130a1, 130b1, 130a2, and 130b2 are provided by using, for example, multi-patterning technology (MPT). In some embodiments, the line patterns 130a1, 130b1, 130a2, and 130b2 are provided by using quadruple patterning technology (QPT).

In some embodiments, the conductive patterns 130 have a single layer. In other embodiments, as illustrated in FIGS. 3 and 4, the conductive patterns 130 include multiple layers. For example, the conductive patterns 130 include first sub-conductive layers 132, second sub-conductive layers 134, and third sub-conductive layers 136 that are sequentially stacked on the substrate 100. The first sub-conductive layers 132, the second sub-conductive layers 134, and the third sub-conductive layers 136 each include a conductive material, such as at least one of polysilicon, TiN, TiSiN, tungsten (W), or tungsten silicide, or a combination thereof. For example, the first sub-conductive layers 132 includes polysilicon, the second sub-conductive layers 134 includes TiSiN, and the third sub-conductive layers 136 includes W.

The first capping patterns 137 are formed on the conductive patterns 130. The first capping patterns 137 extend along the top surfaces of the conductive patterns 130. In some embodiments, the first capping patterns 137 have a single layer. In other embodiments, as illustrated in FIGS. 3 and 4, the first capping patterns 137 include multiple layers. For example, the first capping patterns 137 include first sub-capping patterns 138 and second sub-capping patterns 139 that are sequentially stacked on the conductive patterns 130. The first sub-capping patterns 138 and the second sub-capping patterns 139 each include an insulating material, such as at least one of silicon oxide, silicon nitride, silicon oxynitride, or silicon oxycarbide, or a combination thereof. For example, the first sub-capping patterns 138 and second sub-capping patterns 139 each include silicon nitride.

The gate electrodes 160 are formed on the substrate 100 and the device isolation patterns 110. The gate electrodes 160 cross both the active regions AR and the conductive patterns 130. For example, the gate electrodes 160 extend longitudinally in the second direction Y, diagonally crossing the active regions AR, and also perpendicularly cross the conductive patterns 130. In addition, the gate electrodes 160 traverse parts of the active regions AR between the first portions, such as the central parts, and the second portions, such as both end parts, of the active regions AR. For example, the gate electrodes 160 pass through the active regions AR between the direct contacts DC and the buried contacts BC. Multiple gate electrodes 160 are arranged along the first direction X. The gate electrodes 160 may be word lines.

In some embodiments, the gate electrodes 160 have a single layer. In other embodiments, as illustrated in FIG. 4, the gate electrodes 160 include multiple layers. For example, the gate electrodes 160 include fourth sub-conductive layers 164 and fifth sub-conductive layers 166 that are sequentially stacked on the substrate 100. The fourth sub-conductive layers 164 and the fifth sub-conductive layers 166 each include a material such as a metal, polysilicon, or a combination thereof, but embodiments of the present disclosure are not necessarily limited thereto. For example, the fourth sub-conductive layers 164 include TiN, and the fifth sub-conductive layers 166 include n-type doped polysilicon.

The gate dielectric layers 162 are interposed between the gate electrodes 160 and the substrate 100 (or the active regions AR). The gate dielectric layers 162 include at least one of, for example, silicon oxide, silicon oxynitride, silicon nitride, or a material with a greater dielectric constant than silicon oxide, but embodiments of the present disclosure are not necessarily limited thereto.

The second capping patterns 168 are formed on the gate electrodes 160. The second capping pattern 168 extends along the top surfaces of the gate electrodes 160. The second capping patterns 168 include an insulating material, such as at least one of silicon oxide, silicon nitride, silicon oxynitride, or silicon oxycarbide, or a combinations thereof, but embodiments of the present disclosure are not necessarily limited thereto. The second capping patterns 168 may be single layers or multilayers that include various combinations of insulating materials.

In some embodiments, the gate electrodes 160 are buried within the substrate 100. For example, the substrate 100 includes gate trenches WT that extend in the second direction Y. The gate dielectric layers 162 extend along the profile of the gate trenches WT. The gate electrodes 160 fill portions of the gate trenches WT on the gate dielectric layers 162. The second capping patterns 168 fill other portions of the gate trenches WT on the gate electrodes 160. For example, the top surfaces of the gate electrodes 160 are lower than the surface of the substrate 100.

The direct contacts DC are formed on the substrate 100 and the device isolation patterns 110. The direct contacts DC connect the active regions AR of the substrate 100 with the conductive patterns 130. For example, the substrate 100 includes first contact trenches CT1 that penetrate through the base insulating layer 120 and expose the first portions, such as the central parts, of the active regions AR. The direct contacts DC are formed within the first contact trenches CT1 to connect the active regions AR of the substrate 100 with the conductive patterns 130.

In some embodiments, the first contact trenches CT1 expose the central parts of the active regions AR. For example, the direct contacts DC are connected to the central parts of the active regions AR.

The direct contacts DC include a conductive material, such as at least one of polysilicon, TiN, TiSiN, W, tungsten silicide, or a combination thereof, but embodiments of the present disclosure are not necessarily limited thereto. For example, the direct contacts DC include polysilicon. The conductive patterns 130 are electrically connected to the active regions AR of the substrate 100 through the direct contacts DC.

The spacer structures 140 are formed on the sides of the conductive patterns 130. The spacer structures 140 extend along the sides of the conductive patterns 130 and the sides of the first capping patterns 137. In some embodiments, the height of the spacer structures 140 is the same as or lower than the top surfaces of the first capping patterns 137.

The spacer structures 140 include an insulating material, such as at least one of silicon oxide, silicon nitride, silicon oxynitride, or silicon oxycarbide, or a combination thereof, but embodiments of the present disclosure are not necessarily limited thereto.

In some embodiments, the spacer structures 140 have multiple layers that include various combinations of insulating materials. For example, the spacer structures 140 include base spacers 141, first lower spacers 142, second lower spacers 143, first side spacers 144, and second side spacers 145.

The base spacers 141 are formed on the sides of the conductive patterns 130. For example, the base spacers 141 extend conformally along at least some of the profiles of the sides of the conductive patterns 130 and the sides of the first capping patterns 137. In some embodiments, the base spacers 141 are the innermost spacers of the spacer structures 140 in contact with the conductive patterns 130 and the direct contacts DC.

The first lower spacers 142 are formed on the base spacers 141 within the first contact trenches CT1. For example, the first lower spacers 142 conformally extend along the profile of the base spacers 141 within the first contact trenches CT1.

The second lower spacers 143 are formed on the first lower spacers 142 within the first contact trenches CT1. For example, the second lower spacers 143 fill the remaining regions of the first contact trenches CT1 after the base spacers 141 and the first lower spacers 142 have been formed.

The first side spacers 144 are formed on the outer sides of the base spacers 141. In addition, the first side spacers 144 are also formed on the first lower spacers 142 and the second lower spacers 143. For example, the first side spacers 144 extend conformally along portions of the sides of the first capping patterns 137 and the profile of the conductive patterns 130.

The second side spacers 145 are formed on the outer sides of the first side spacers 144. In addition, the second side spacers 145 are also formed on the second lower spacers 143. For example, the second side spacers 145 extend conformally along portions of the sides of the first capping patterns 137 and the profile of the conductive patterns 130. In some embodiments, the second side spacers 145 are the outermost spacers in contact with the buried contacts BC.

The base spacers 141, the first lower spacers 142, the second lower spacers 143, the first side spacers 144, and the second side spacers 145 each include an insulating material, such as at least one of silicon oxide, silicon nitride, silicon oxynitride, or silicon oxycarbide, or a combination thereof, but embodiments of the present disclosure are not necessarily limited thereto.

The buried contacts BC are formed on the substrate 100 and the device isolation patterns 110. The buried contacts BC connect the active regions AR of the substrate 100 with the landing pads LP. For example, the substrate 100 includes second contact trenches CT2 that penetrate through the base insulating layer 120 and expose the second portions of the active regions AR. The buried contacts BC are formed within the second contact trenches CT2 and connect the active regions AR of the substrate 100 with the landing pads LP.

In some embodiments, the second contact trenches CT2 expose both end parts of the active regions AR. For example, the buried contacts BC are connected to both end parts of the active regions AR.

The buried contacts BC are formed on the side surfaces of the conductive patterns 130. In addition, the buried contacts BC are spaced apart from the conductive patterns 130 by the spacer structures 140. For example, as illustrated in FIG. 3, the buried contacts BC extend along portions of the outer side surfaces of the spacer structures 140. Multiple buried contacts BC arranged along the first direction X are spaced apart from each other by the conductive patterns 130 and the spacer structures 140 that extend longitudinally in the first direction X. In some embodiments, the top surfaces of the buried contacts BC are lower than the top surfaces of the first capping patterns 137.

The buried contacts BC form multiple isolated regions spaced apart from each other. For example, the buried contacts BC are interposed between the conductive patterns 130 and between the gate electrodes 160. In some embodiments, the buried contacts BC are arranged in a lattice structure.

The buried contacts BC include a conductive material, such as at least one of polysilicon, TiN, TiSiN, W, or tungsten silicide, or a combination thereof, but embodiments of the present disclosure are not necessarily limited thereto. For example, the buried contacts BC include polysilicon.

The landing pads LP are formed on the buried contacts BC. The landing pads LP are electrically connected to the buried contacts BC. In some embodiments, the landing pads LP at least partially overlap the buried contacts BC. For example, as illustrated in FIG. 3, some portions of the landing pads LP overlap the buried contacts BC, while other portions of the landing pads LP overlap some portions of the spacer structures 140 and some portions of the first capping patterns 137.

The landing pads LP include a conductive material, such at least one of as polysilicon, TiN, TiSiN, W, or tungsten silicide, or a combination thereof, but embodiments of the present disclosure are not necessarily limited thereto. For example, the landing pads LP include W. The capacitor structures 190 are electrically connected to the active regions AR of the substrate 100 through the buried contacts BC and the landing pads LP.

The landing pads LP form multiple isolated regions spaced apart from each other. For example, pad trenches PT that define the landing pads LP are formed. The pad trenches PT extend downward from the top surfaces of the landing pads LP, and the bottom surfaces of the pad trenches PT are lower than the top surfaces of the spacer structures 140. In addition, at least some portions of the pad trenches PT overlap at least some portions of the spacer structures 140. For example, the pad trenches PT overlap some portions of the spacer structures 140 and some portions of the first capping patterns 137. For example, the landing pads LP are separated from each other by the pad trenches PT.

In some embodiments, isolation patterns 180 that fill the pad trenches PT are formed. The isolation patterns 180 include an insulating material such as at least one of, for example, silicon oxide, silicon oxynitride, silicon nitride, or a material with a lower dielectric constant than silicon oxide, but embodiments of the present disclosure are not necessarily limited thereto. The landing pads LP are electrically separated from each other by the isolation patterns 180.

In some embodiments, the landing pads LP have a honeycomb structure. The landing pads LP arranged in a honeycomb structure can improve the integration level of a semiconductor device.

The capacitor structures 190 are formed on the isolation patterns 180 and the landing pads LP. The capacitor structures 190 are connected to the top surfaces of the landing pads LP. For example, the isolation patterns 180 expose at least some portions of the top surfaces of the landing pads LP. The capacitor structures 190 are connected to at least some portions of the exposed top surfaces of the landing pads LP through the isolation patterns 180. For example, the capacitor structures 190 is electrically connected to the active regions AR of the substrate 100 through the buried contacts BC and the landing pads LP.

The capacitor structures 190 store data and are controlled by the conductive patterns 130 and the gate electrodes 160. In some embodiments, the capacitor structures 190 include sub-electrodes 192, capacitor dielectric layers 194, and upper electrodes 196 that are sequentially stacked on the landing pads LP. The capacitor structures 190 store charge within the capacitor dielectric layers 194 using the potential difference generated between the sub-electrodes 192 and the upper electrodes 196.

The sub-electrodes 192 and the upper electrodes 196 include, for example, at least one of doped polysilicon, a metal, or a metal nitride, but are not necessarily limited thereto. In addition, the capacitor dielectric layers 194 include, for example, at least one of silicon oxide or a high-k material, but embodiments of the present disclosure are not necessarily limited thereto.

The contact plugs CP are electrically connected to the conductive patterns 130. For example, the contact plugs CP are connected to the first line patterns 130a1 of the first conductive patterns 1301 of the conductive patterns 130 and the second line patterns 130b 1 of the second conductive patterns 1302 of the conductive patterns 130. Some control elements in the peripheral region PR are connected to the conductive patterns 130 by the contact plugs CP and control the semiconductor device, according to some embodiments. For example, sense amplifiers in the second peripheral region PR2 are connected to the conductive patterns 130 by the contact plugs CP.

In some embodiments, each of the conductive patterns 130 is commonly connected to a corresponding pair of neighboring active regions AR in the second direction Y. For example, one of two neighboring active regions AR in the second direction Y is connected to the first line pattern 130a1 of each of the conductive patterns 130, while the other active region AR is connected to the second line pattern 130b 1 of the corresponding conducive pattern 130. In addition, in some embodiments, the two neighboring active regions AR share one gate electrode 160 that extends in the second direction Y. For example, a semiconductor memory device with improved unit-memory cell storage capacity, such as capacitance, can be provided.

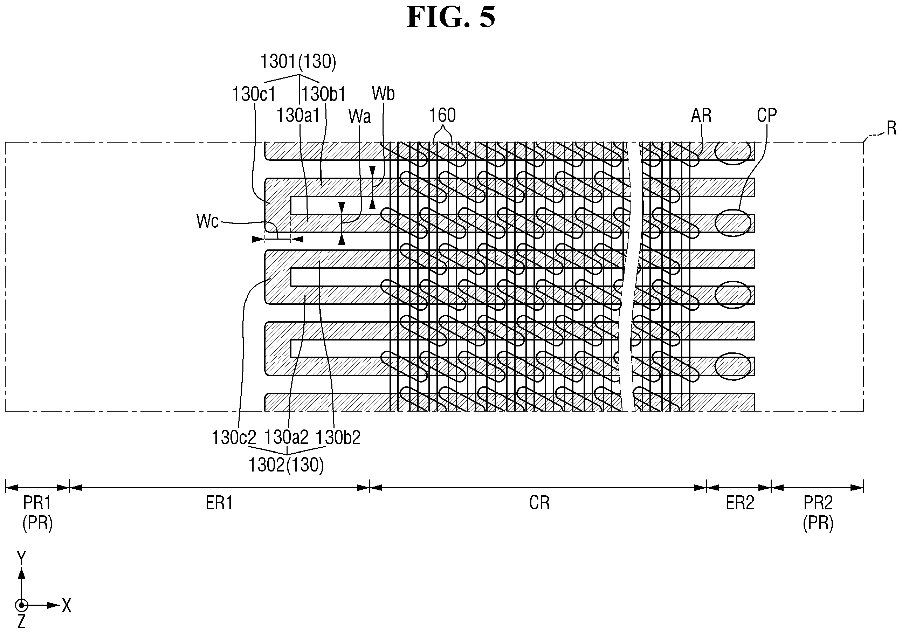

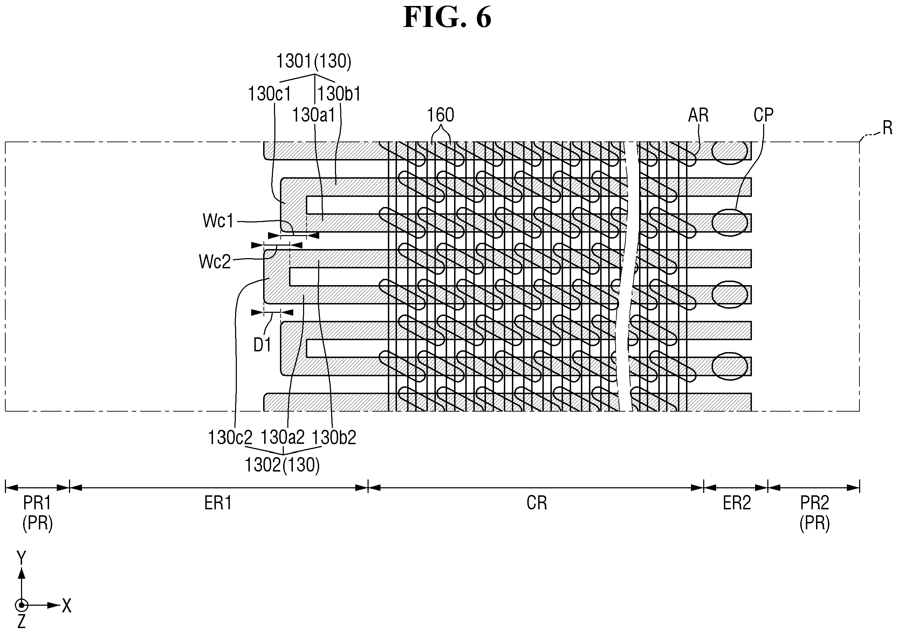

FIGS. 5 and 6 are enlarged layout views of regions R (of FIG. 1) of semiconductor devices according to some embodiments. For convenience, descriptions of components described above with reference to FIGS. 1 through 4 will be summarized or omitted.

Referring to FIG. 5, in some embodiments, folding patterns 130c1 and 130c2 have a greater width than line patterns 130a1, 130b 1, 130a2, and 130b2.

For example, a width Wc of a first folding pattern 130c1 in a first direction X is greater than a width Wa of a first line pattern 130a1 in a second direction Y, and a width Wc of a first folding pattern 130c1 in the first direction X is greater than a width Wb of a second line pattern 130b1 in the second direction Y. The widths Wa and Wb of the first and second line patterns 130a1 and 130b1 are the same.

Referring to FIG. 6, in some embodiments, conductive patterns 130 alternately protrude in a first direction X.

For example, a second folding pattern 130c2 of a second conductive pattern 1302 protrudes by a distance D1 in the first direction X toward a first peripheral region PR1 from a first folding pattern 130c1 of a first conductive pattern 1301. The first conductive pattern 1301 and a second conductive pattern 1302 are alternately and repeatedly arranged in a second direction Y.

In some embodiments, a width Wc1 of the first folding pattern 130c1 and a width Wc2 of the second folding pattern 130c2 are each greater than the width of line patterns 130a1, 130b1, 130a2, and 130b2. The widths Wc1 and Wc2 are illustrated as being the same, but embodiments of the present disclosure are not necessarily limited thereto. In other embodiments, the widths Wc1 and Wc2 differ.

A method of fabricating a semiconductor device according to some embodiments will hereinafter be described with reference to FIGS. 1 through 53.

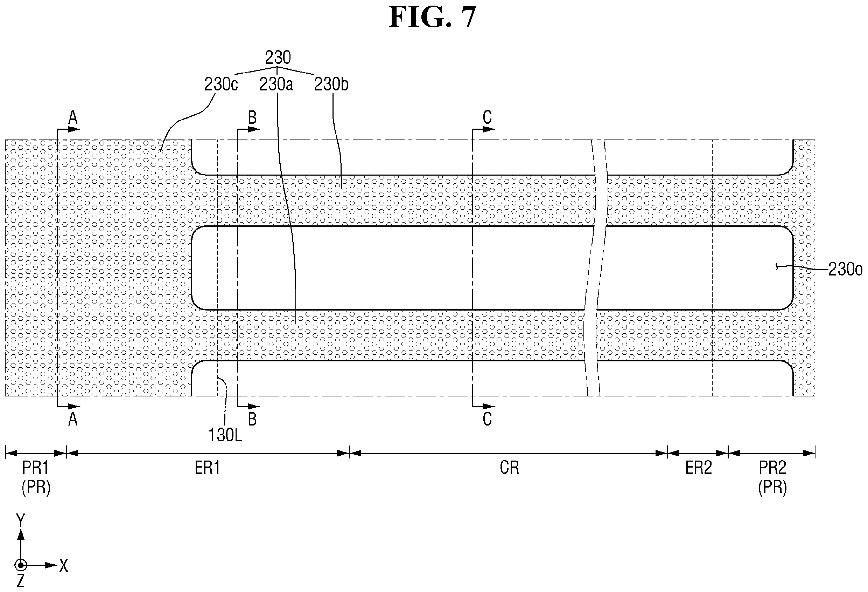

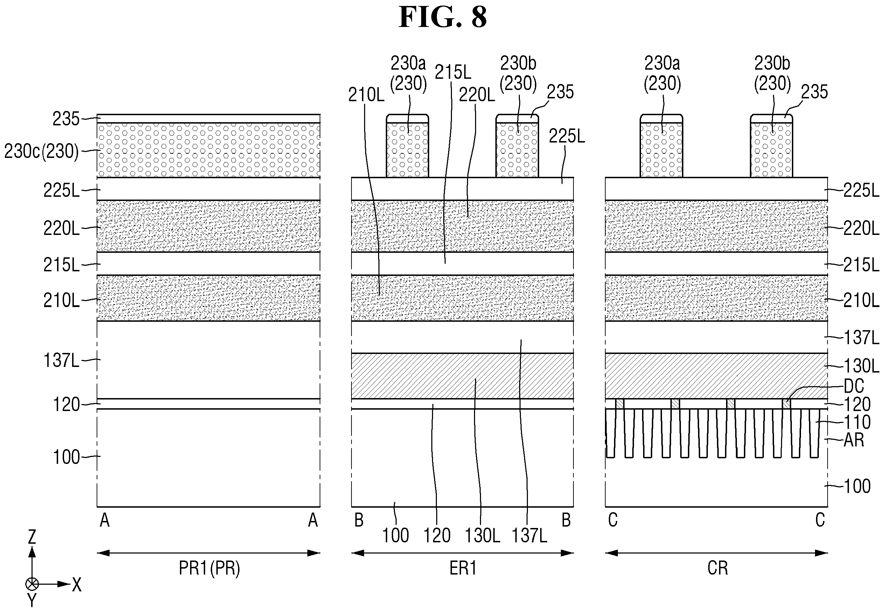

FIGS. 7 through 32 illustrate intermediate steps of a method of fabricating a semiconductor device according to some embodiments. For example, FIGS. 8, 10, 12, 14, 16, 18, 20, 22, 24, 27, 30, and 32 are cross-sectional views taken along lines A-A, B-B, and C-C of FIGS. 7, 9, 11, 13, 15, 17, 19, 21, 23, 26, 29, and 31, respectively. For convenience, descriptions of components described above with reference to FIGS. 1 through 4 will be summarized or omitted.

Referring to FIGS. 7 and 8, in an embodiment, a target film 130L, a first mask film 210L and 215L, a second mask film 220L and 225L, and an upper mask pattern 230 and 235 are formed on a substrate 100.

The target film 130L includes various materials that can be patterned by patterning processes that form the patterns of a semiconductor device. For example, the target film 130L includes one or more of a conductive film, an insulating film, or a semiconductor film stacked on the substrate 100. For example, the target film 130L is a portion of the substrate 100. The target film 130L may be a single film or include multiple films that include a stack of multiple material films. The target film 130L will hereinafter be described as being, for example, a conductive film stacked on the substrate 100, but embodiments of the present disclosure are not necessarily limited thereto.

In some embodiments, the target film 130L includes a conductive film for forming bitlines. For example, device isolation patterns 110 that define a plurality of active regions AR in the substrate 100 are formed in the substrate. Thereafter, a base insulating film 120 is formed on the substrate 100. Thereafter, direct contacts DC are formed that connect the target film 130L with the active regions AR. Thereafter, a capping film 137L that includes an insulating material is formed on the target film 130L.

The target film 130L includes at least one of polysilicon, TiN, TiSiN, W, or tungsten silicide, or a combination thereof, but embodiments of the present disclosure are not necessarily limited thereto. For example, the target film 130L includes a polysilicon film, a TiSiN film, and a W film that are sequentially stacked on the substrate 100.

In some embodiments, the target film 130L is formed across a first boundary region ER1, a cell region CR, and a second boundary region ER2.

The first mask film 210L and 215L and the second mask film 220L and 225L are sequentially stacked on the target film 130L and/or the capping film 137L. The first mask film 210L and 215L and the second mask film 220L and 225L are different types of mask films that depend on the material included in the target film 130L and/or the capping film 137L. The first mask film 210L and 215L contains a material with etch selectivity with respect to the target film 130L and/or the capping film (137L). The second mask film 220L and 225L includes a material with etch selectivity with respect to the first mask film 210L and 215L.

The first mask film 210L and 215L and the second mask film 220L and 225L include at least one of, for example, a silicon-containing material such as silicon oxide, silicon oxynitride, silicon nitride, or polysilicon, a carbon-containing material such as amorphous carbon layer (ACL) or spin-on-hardmask (SOH), a bottom anti-reflective coating (BARC), a metal, or an organic material, but embodiments of the present disclosure are not necessarily limited thereto.

In some embodiments, the first mask film 210L and 215L includes a first hard mask film 210L and a first antireflection film 215L that are sequentially stacked on the target film 130L and/or the capping film 137L. For example, the first hard mask film 210L includes an ACL film, and the first antireflection film 215L includes a SiON film.

In some embodiments, the second mask film 220L and 225L includes a second hard mask film 220L and a second antireflection film 225L that are sequentially stacked on the first mask film 210L and 215L. For example, the second hard mask film 220L includes an ACL film, and the second antireflection film 225L includes a SiON film.

The upper mask pattern 230 and 235 is formed on the second mask film 220L and 225L. The upper mask pattern 230 and 235 includes a material with etch selectivity with respect to the second mask film 220L and 225L. For example, the upper mask pattern 230 and 235 includes at least one of, for example, a silicon-containing material such as silicon oxide, silicon oxynitride, silicon nitride, or polysilicon, a carbon-containing material such as ACL or SOH, a BARC, a metal, or an organic material, but embodiments of the present disclosure are not necessarily limited thereto.

In some embodiments, the upper mask pattern 230 and 235 includes an upper hard mask pattern 230 and upper antireflection patterns 235 that are sequentially stacked on the second mask film 220L and 225L. For example, the upper hard mask pattern 230 includes SOH films, and the upper antireflection patterns 235 includes SiON films.

The upper mask pattern 230 and 235 includes a plurality of upper mask lines 230a and 230b that extend parallel to the first direction X. For example, the upper mask lines 230a and 230b extend longitudinally in the first direction X and include first upper mask lines 230a and second upper mask lines 230b that are arranged along the second direction Y.

The upper mask lines 230a and 230b extend longitudinally in the first direction X, traversing the cell region CR. For example, the upper mask lines 230a and 230b extend along the first direction X, traversing the first boundary region ER1, the cell region CR, the second boundary region ER2, and a second peripheral region PR2.

In some embodiments, the upper mask pattern 230 and 235 further includes an upper mask base 230c. The upper mask base 230c covers the first peripheral region PR1 and portions of the first boundary region ER1. The upper mask lines 230a and 230b extend from the upper mask base 230c along the first direction X. The upper mask lines 230a and 230b and the upper mask base 230c define a plurality of upper mask openings 230o that extend parallel to the first direction X within the upper mask pattern 230 and 235. For example, the first upper mask lines 230a and the second upper mask lines 230b define side surfaces of the upper mask openings 230o that intersect with the second direction Y, and the upper mask base 230c defines side surfaces of the upper mask openings 230o that intersect with the first direction X.

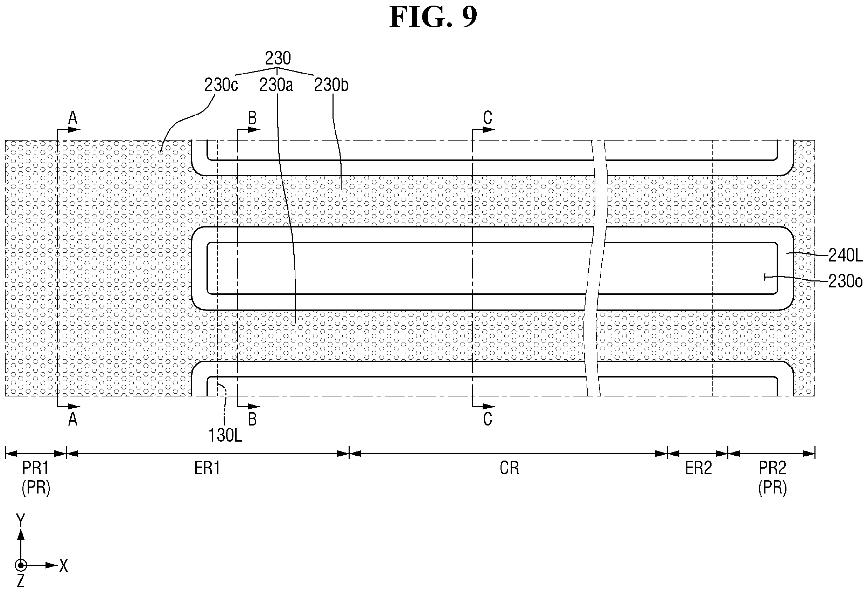

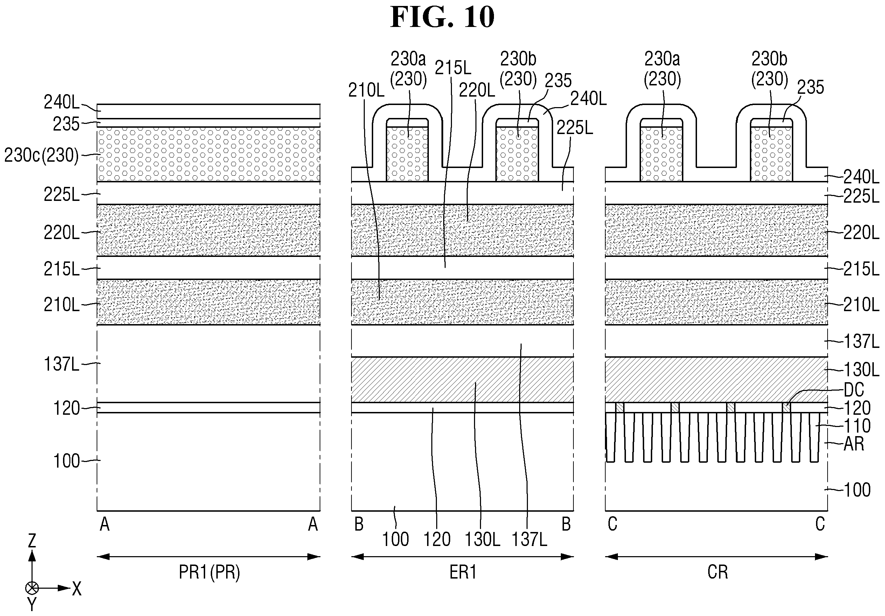

Referring to FIGS. 9 and 10, in an embodiment, first spacer films 240L are formed on the structure depicted in FIGS. 7 and 8.

The first spacer films 240L covers the second mask film 220L and 225L and the upper mask film 230 and 235. For example, the first spacer films 240L extends conformally along the top surface of the second mask film 220L and 225L and the side surfaces and top surface of the upper mask pattern 230 and 235.

The first spacer films 240L includes a material with etch selectivity with respect to the second mask film 220L and 225L and the upper mask film 230 and 235. For example, the first spacer films 240L include at least one of silicon oxide, silicon nitride, or silicon oxynitride. For example, the first spacer films 240L includes silicon oxide films.

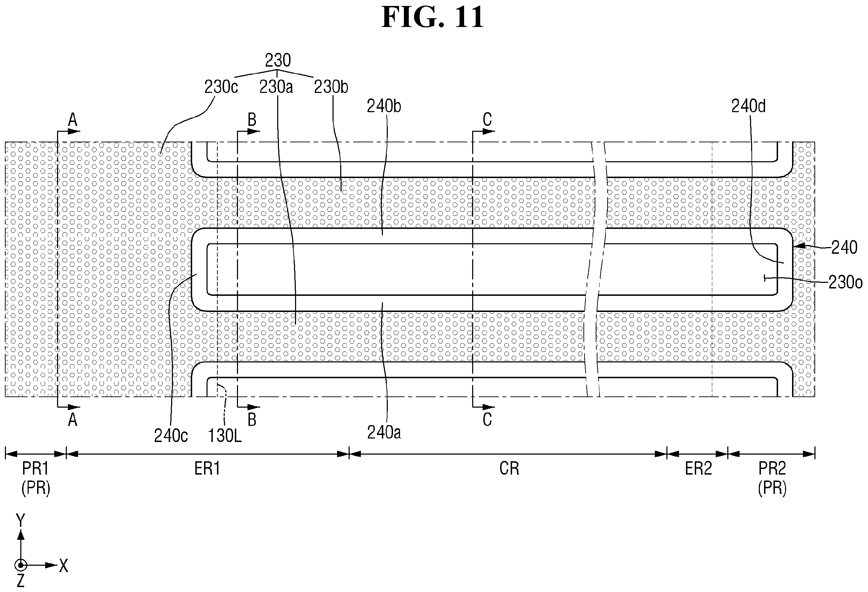

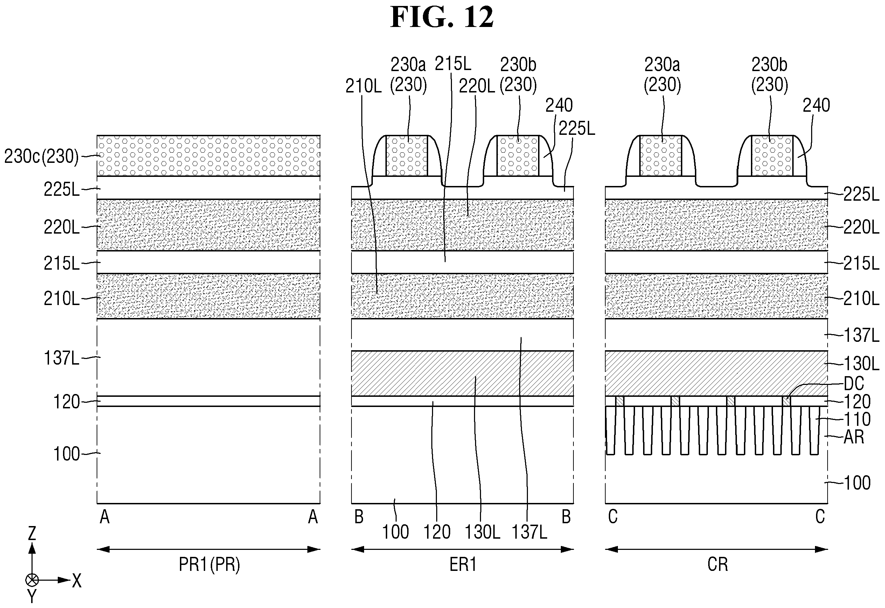

Referring to FIGS. 11 and 12, in an embodiment, first spacer patterns 240 are formed by performing an etching process for the first spacer films 240L.

As a result of the etching process for the first spacer films 240L, portions of the first spacer films 240L that cover the top surface of the second mask film 220L and 225L and the top surface of the upper mask pattern 230 and 235 removed. For example, the first spacer patterns 240 that extend along the side surfaces of the upper mask pattern (230 and 235) are formed.

The first spacer patterns 240 includes first line portions 240a, second line portions 240b, first folding portions 240c, and second folding portions 240d. The first line portions 240a extend in the first direction X along the side surfaces of the first upper mask lines 230a. The second line portions 240b extend in the first direction X along the side surfaces of the second upper mask lines 230b. The first folding portions 240c connect the first line portions 240a and the second line portions 240b in the first boundary region ER1. For example, the first folding portions 240c are bent from first ends of the first line portions 240a and first ends of the second line portions 240b and extend in the second direction Y. The second folding portions 240d connect the first line portions 240a and the second line portions 240b on the opposite sides of the first folding portions 240c. For example, the second folding portions 240d are bent from second ends of the first line portions 240a and second ends of the second line portions 240b and extend in the second direction Y. In some embodiments, the first line portions 240a, the second line portions 240b, the first folding portions 240c, and the second folding portions 240d extend along the side surfaces of the upper mask openings 230o.

In some embodiments, the first folding portions 240c overlap the target film 130L in a third direction Z. For example, the first folding portions 240c are disposed in the first boundary region ER1.

In some embodiments, the second folding portions 240d do not overlap the target film 130L in the third direction Z. For example, the second folding portions 240d are disposed in the second peripheral region PR2.

In some embodiments, the upper antireflection patterns 235 are removed by the etching process for the first spacer films 240L. For example, the etching process for the first spacer films 240L continues until the upper hard mask pattern 230 is exposed. In some embodiments, the second antireflection film 225L is used as an etch stopper film during the etching process for the first spacer films 240L. Portions of the second antireflection film 225L are removed by the etching process for the first spacer films 240L.

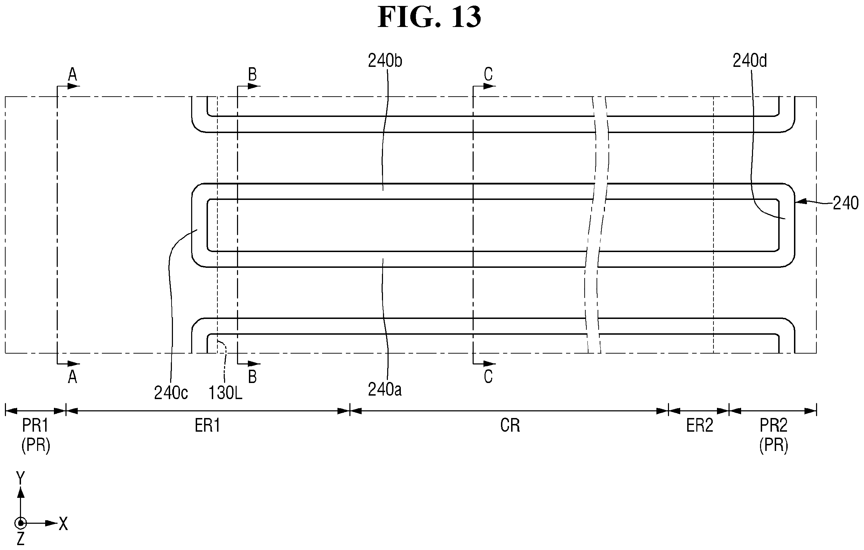

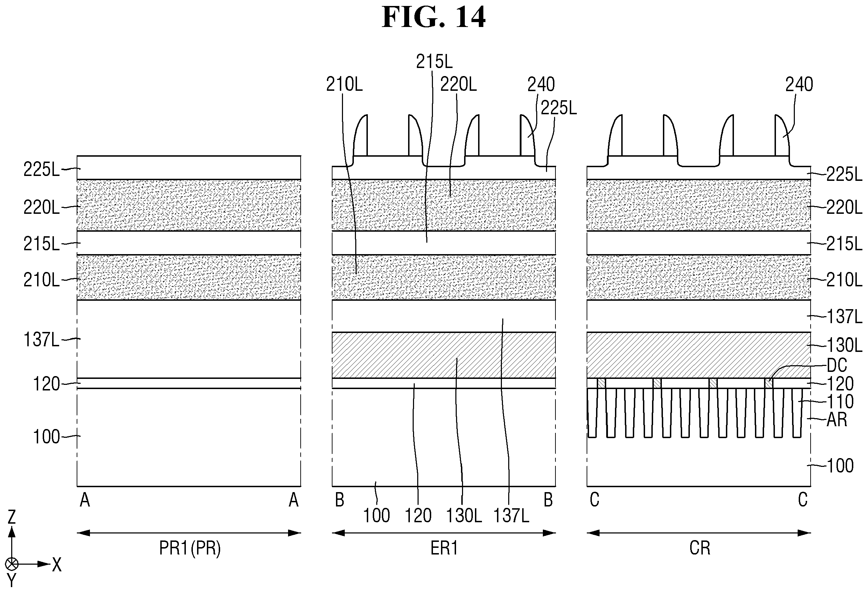

Referring to FIGS. 13 and 14, in an embodiment, the upper mask pattern 230 and 235 is removed.

The upper mask pattern 230 and 235 is selectively removed with respect to the second mask film 220L and 225L and the first spacer patterns 240. For example, portions of the upper hard mask pattern 230 exposed between the first spacer patterns 240 are removed. The upper hard mask pattern 230 can be removed by, for example, an ashing process and/or a stripping process, but embodiments of the present disclosure are not necessarily limited thereto.

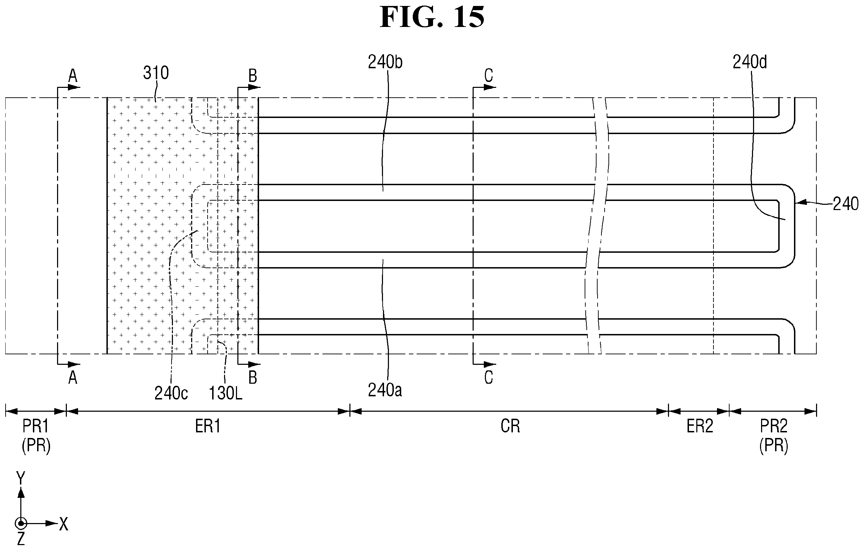

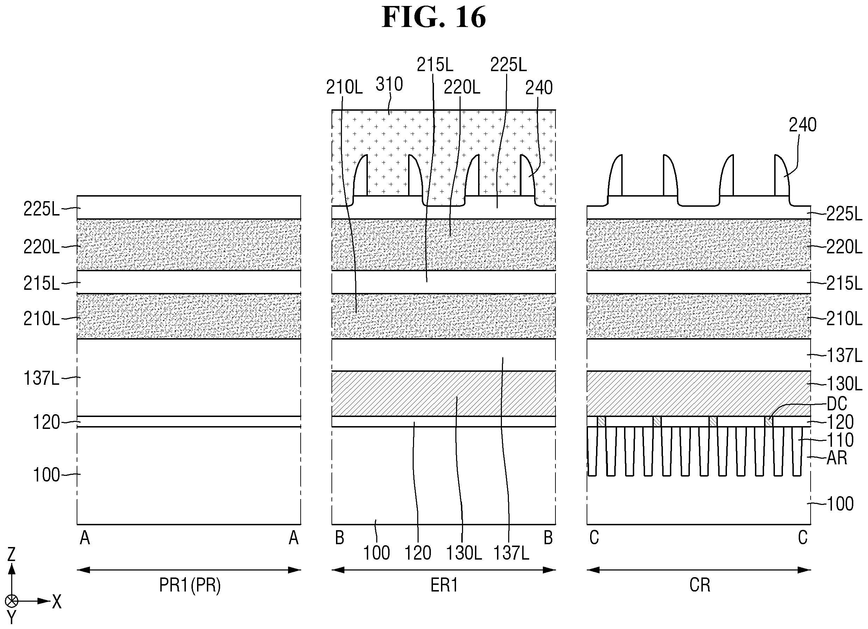

Referring to FIGS. 15 and 16, in an embodiment, a slit mask pattern 310 that covers at least part of the first boundary region ER1 is formed.

The slit mask pattern 310 is formed on the second mask film 220L and 225L and the first spacer patterns 240. The slit mask pattern 310 covers the first folding portions 240c that are disposed in the first boundary region ER1. For example, the slit mask pattern 310 covers the first folding portions 240c, parts of the first line portions 240a that are adjacent to the first folding portions 240c, and parts of the second line portions 240b that are adjacent to the first folding portions 240c.

The slit mask pattern 310 includes a material with etch selectivity with respect to the second mask film 220L and 225L. In some embodiments, the slit mask pattern 310 includes a photoresist.

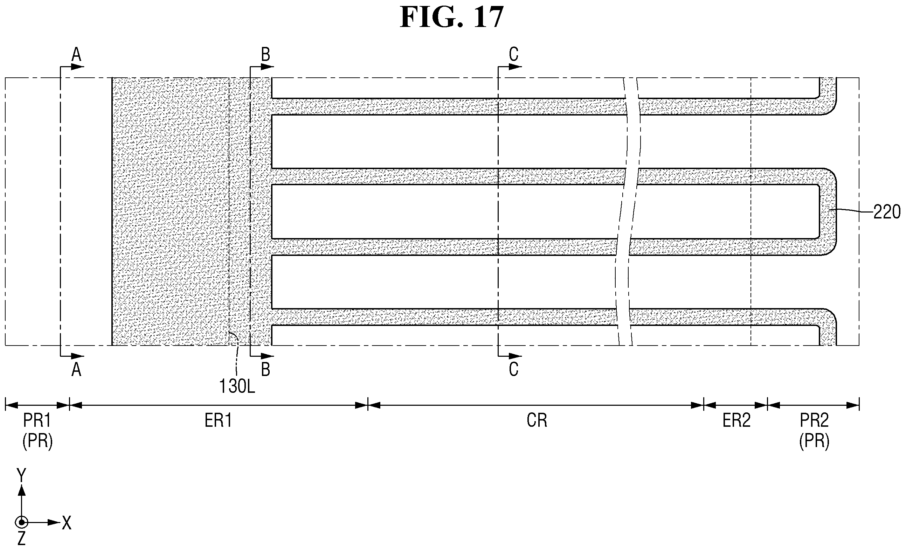

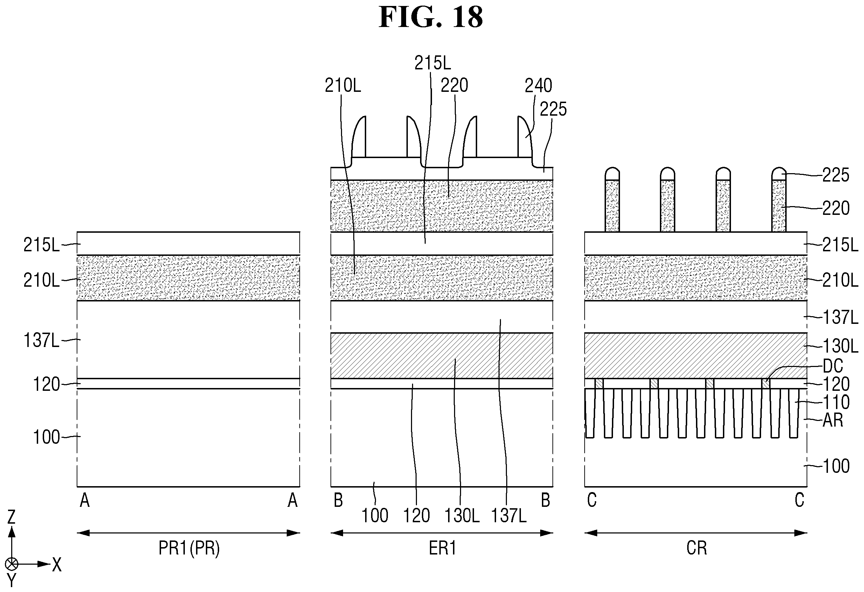

Referring to FIGS. 17 and 18, in an embodiment, a first mask pattern 220 and 225 is formed by patterning the second mask film 220L and 225L using the first spacer patterns 240 and the slit mask pattern 310 as an etching mask.

For example, an etching process for the second mask film 220L and 225L is performed using the first spacer patterns 240 and the slit mask pattern 310 as an etching mask. For example, the first mask pattern 220 and 225 is formed from the first spacer patterns 240 and the slit mask pattern 310. In some embodiments, the first mask pattern 220 and 225 includes a first hard mask pattern 220 and first antireflection patterns 225. The first hard mask pattern 220 is formed from the second hard mask film 220L, and the first antireflection patterns 225 is formed from the second antireflection film 225L.

In some embodiments, the slit mask pattern 310 is removed during the formation of the first mask pattern 220 and 225.

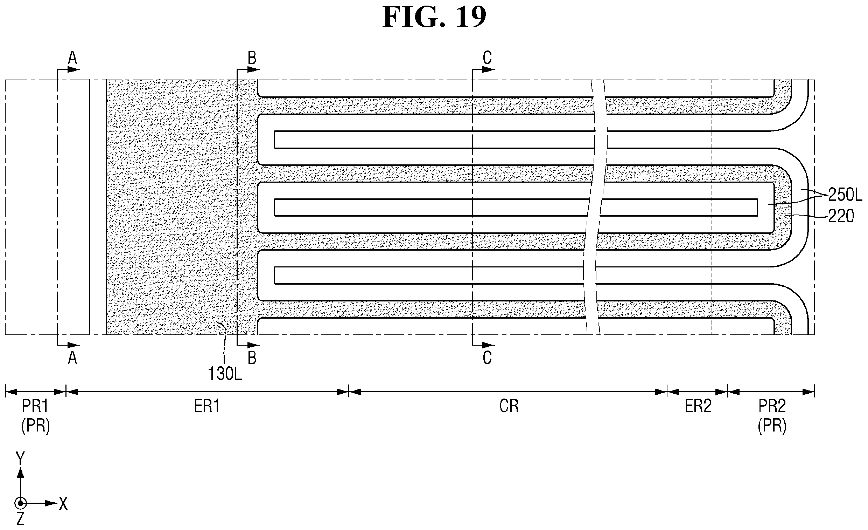

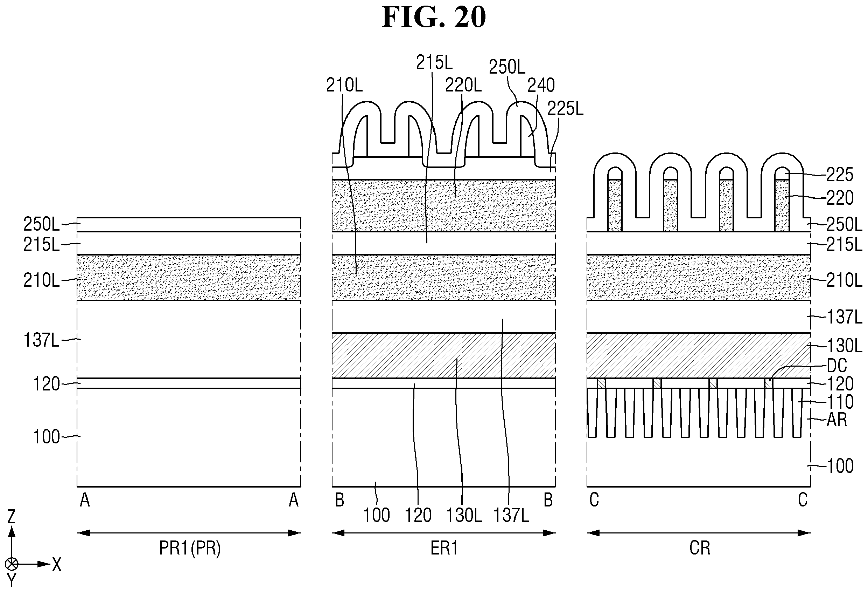

Referring to FIGS. 19 and 20, in an embodiment, second spacer films 250L are formed on the structure depicted in FIGS. 17 and 18.

The second spacer films 250L cover the first mask film 210L and 215L and the first mask pattern 220 and 225. For example, the first spacer films 240L extend conformally along the top surface of the first mask film 210L and 215L and the side surfaces and top surface of the first mask pattern 220 and 225.

The second spacer films 250L include a material with etch selectivity with respect to the first mask film 210L and 215L and the first mask pattern 220 and 225. For example, the second spacer films 250L include at least one of silicon oxide, silicon nitride, or silicon oxynitride. For example, the second spacer films 250L includes silicon oxide films.

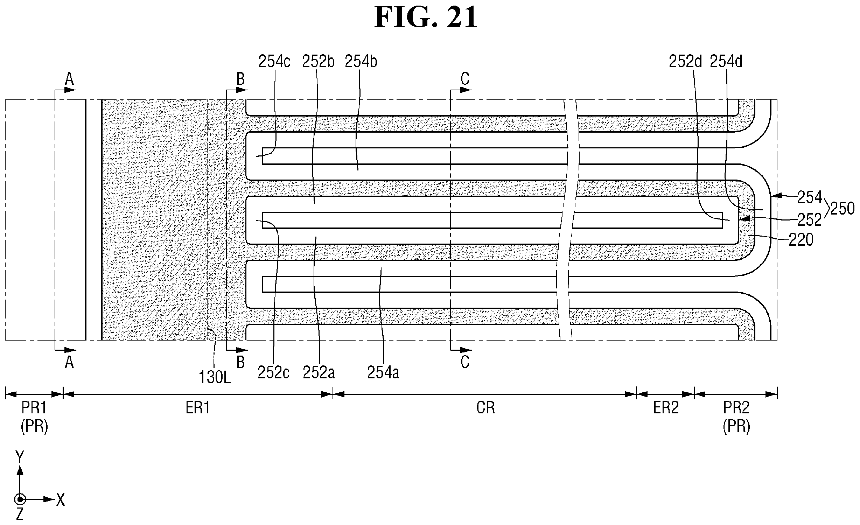

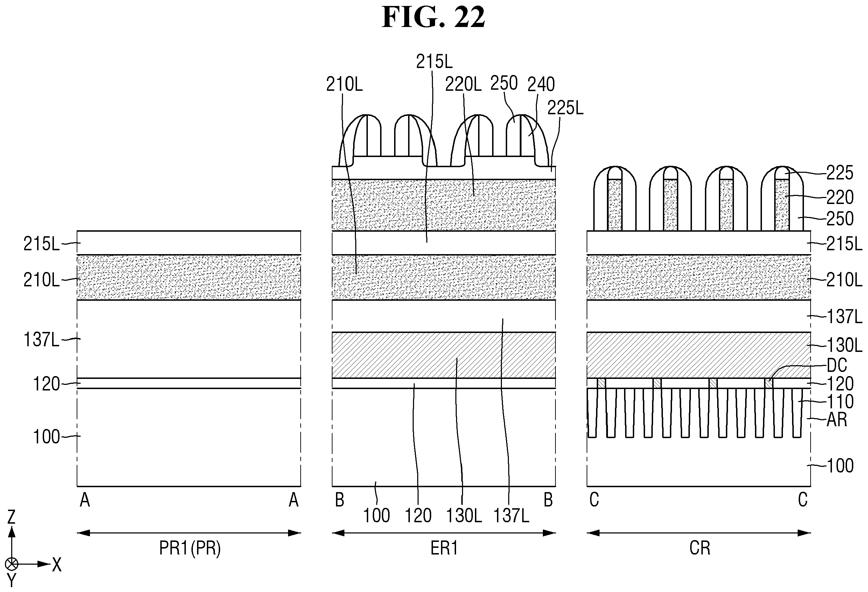

Referring to FIGS. 21 and 22, in an embodiment, second spacer patterns 250 are formed by performing an etching process on the second spacer films 250L.

As a result of the etching process on the second spacer films 250L, portions of the second spacer films 250L that cover the top surface of the first mask film 210L and 215L and the top surface of the first mask pattern 220 and 225 are removed. For example, the second spacer patterns 250 that extend along the side surfaces of the first mask pattern 220 and 225 are formed.

The second spacer patterns 250 include inner spacer patterns 252 and outer spacer patterns 254. The inner spacer patterns 252 extend along the inner side surfaces of the first mask pattern 220 and 225. The outer spacer patterns 254 extend along the outer side surfaces of the second mask pattern 220 and 225. The first mask pattern 220 and 225 is interposed between the inner spacer patterns 252 and the outer spacer patterns 254.

The inner spacer patterns 252 include first inner line portions 252a, second inner line portions 252b, first inner folding portions 252c, and second inner folding portions 252d. The first inner line portions 252a extend in the first direction X. The second inner line portions 252b are opposite to the first inner line portions 252a and extend in the first direction X. The first inner folding portions 252c connect the first inner line portions 252a and the second inner line portions 252b in the first boundary region ER1. For example, the first inner folding portions 252c are bent from first ends of the first inner line portions 252a and first ends of the second inner line portions 252b and extend in the second direction Y. The second inner folding portions 252d connect the first inner line portions 252a and the second inner line portions 252b on the opposite sides of the first inner folding portions 252c. For example, the second inner folding portions 252d are bent from second ends of the first inner line portions 252a and second ends of the second inner line portions 252b and extend in the second direction Y.

The outer spacer patterns 254 include first outer line portions 254a, second outer line portions 254b, first outer folding portions 254c, and second outer folding portions 254d. The first outer line portions 254a and the second outer line portions 254b extend in the first direction X. The first outer line portions 254a and the second outer line portions 254b extend along the circumferences of the first inner line portions 252a and the circumferences of the second inner line portions 252b. For example, the first outer line portions 254a are opposite to the first inner line portions 252a with the first mask pattern 220 and 225 interposed therebetween, and the second outer line portions 254b are opposite to the second inner line portions 252b with the first mask pattern 220 and 225 interposed therebetween. The first outer folding portions 254c connect the corresponding pairs of adj acent first and second outer line portions 254a and 254b in the first boundary region ER1. The first outer folding portions 254c do not extend along the circumferences of the first inner folding portions 252c. For example, the first outer folding portions 254c are bent from first ends of the corresponding pairs of adjacent first and second outer line portions 254a and 254b and extend in the second direction Y. The second outer folding portions 254d connect the first outer line portions 254a and the second outer line portions 254b on the opposite sides of the first outer folding portions 254c. The second outer folding portions 254d extend along the circumferences of the second inner folding portions 252d. For example, the second outer folding portions 254d are bent from second ends of the first outer line portions 254a and second ends of the second outer line portions 254b and extend in the second direction Y.

In some embodiments, the first inner folding portions 252c and the first outer folding portions 254c overlap the target film 130L in the third direction Z. For example, the first inner folding portions 252c and the first outer folding portions 254c are disposed in the first boundary region ER1.

In some embodiments, the second inner folding portions 252d and the second outer folding portions 254d do not overlap the target film 130L in the third direction Z. For example, the first inner folding portions 252c and the first outer folding portions 254c are disposed in the second peripheral region PR2.

In some embodiments, the first inner folding portions 252c and the first outer folding portions 254c are arranged in a row along the second direction Y. For example, the first inner folding portions 252c and the first outer folding portions 254c are aligned along straight lines that extend in the second direction Y.

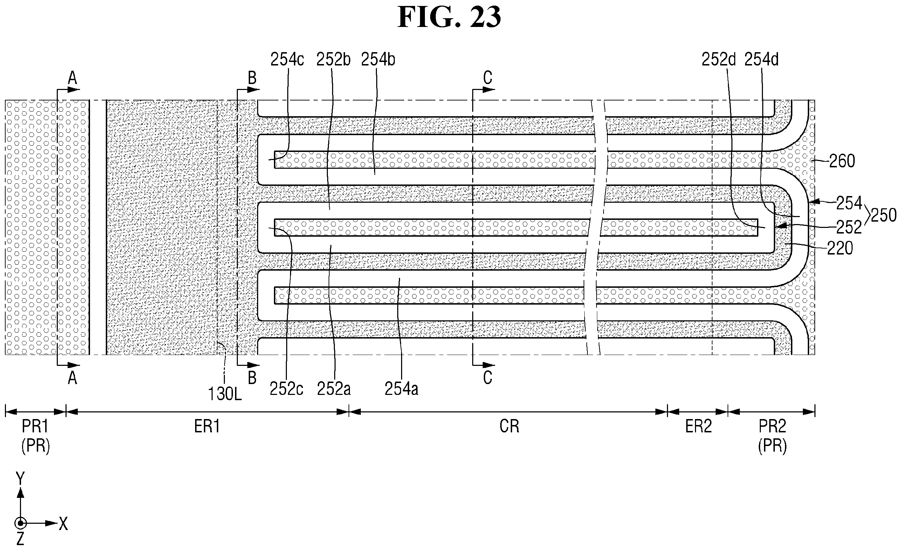

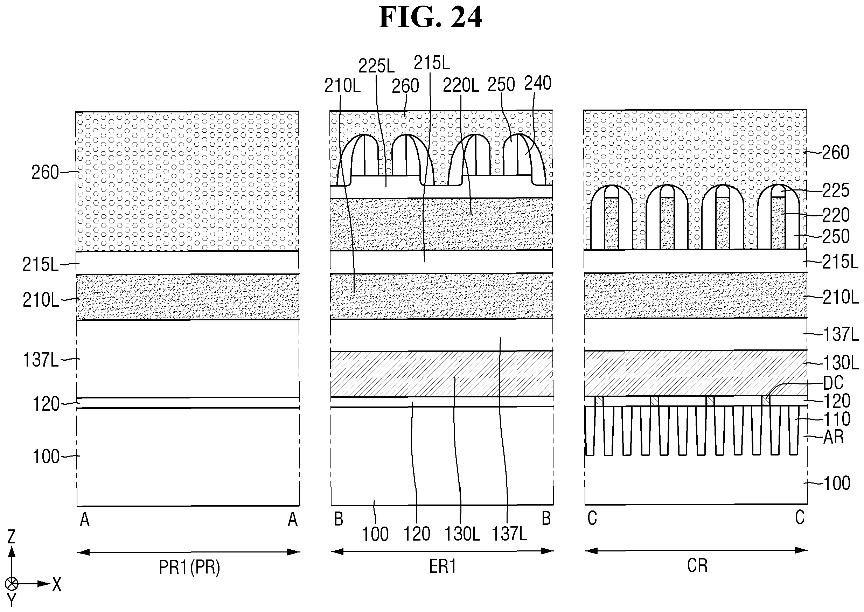

Referring to FIGS. 23 and 24, a gap-fill film 260 is formed on the structure depicted in FIGS. 21 and 22.

The gap-fill film 260 fills the empty spaces on the first mask film 210L and 215L. For example, the gap fill film 260 fills the spaces on the inner sides of the inner spacer patterns 252 and the outer sides of the outer spacer patterns 254. The gap fill film 260 includes a material such as SOH, but embodiments of the present disclosure are not necessarily limited thereto.

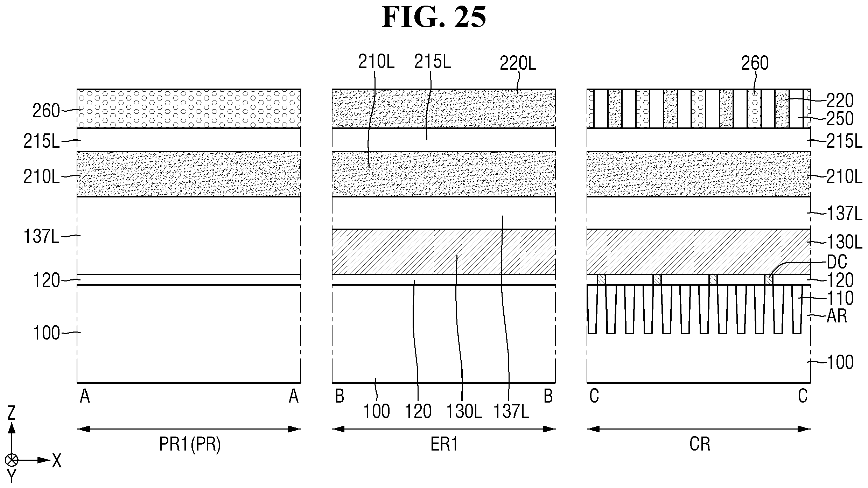

Referring to FIG. 25, in an embodiment, a planarization process is performed on the structure depicted in FIGS. 23 and 24.

An etch-back process is performed as the planarization process, but embodiments of the present disclosure are not necessarily limited thereto. As a result of the planarization process, the top surfaces of the first mask pattern 220 and 225, the second spacer patterns 250, and the gap-fill film 260 are flattened. For example, uniform second spacer patterns 250 are obtained.

In some embodiments, the first antireflection patterns 225 are removed during the planarization process.

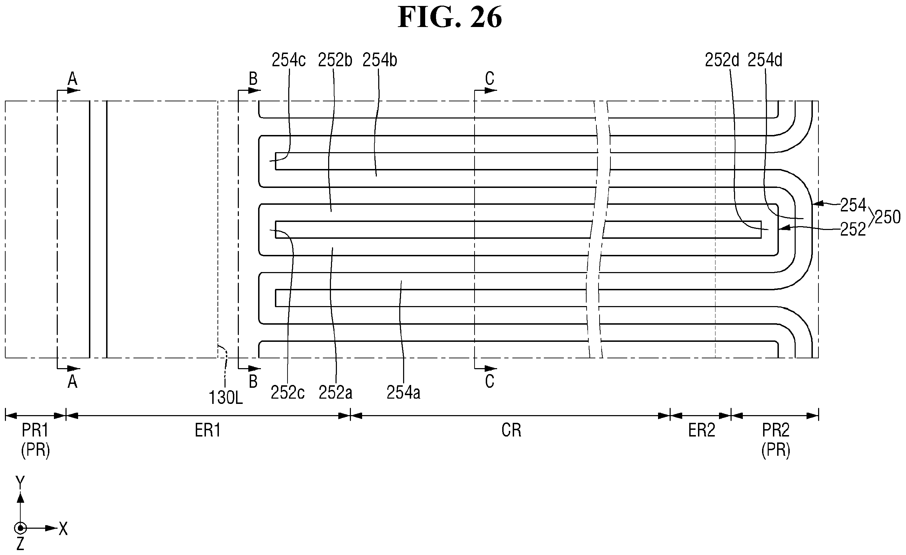

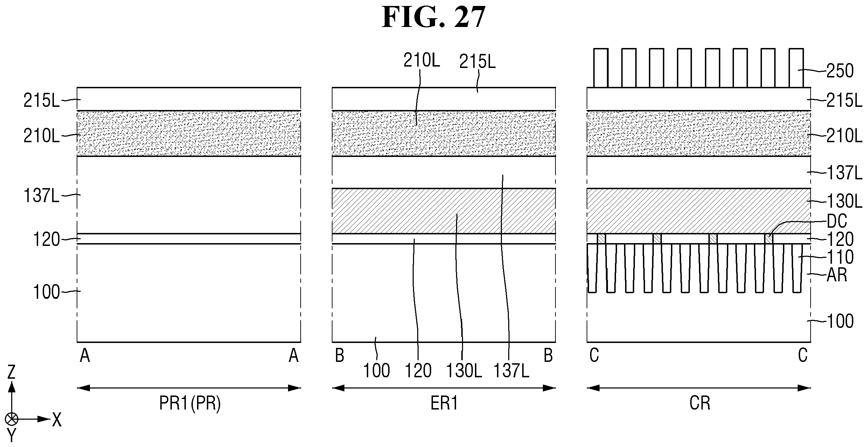

Referring to FIGS. 26 and 27, in an embodiment, the first mask pattern 220 and 225 and the gap-fill film 260 are removed.

The first mask pattern 220 and 225 and the gap-fill film 260 are selectively removed from between the second spacer patterns 250. For example, the first hard mask pattern 220 and portions of the gap-fill film 260 that are exposed between the second spacer patterns 250 are removed. The removal of the first hard mask pattern 220 and the gap-fill film 260 can be performed by, for example, an ashing process and/or a stripping process, but embodiments of the present disclosure are not necessarily limited thereto.

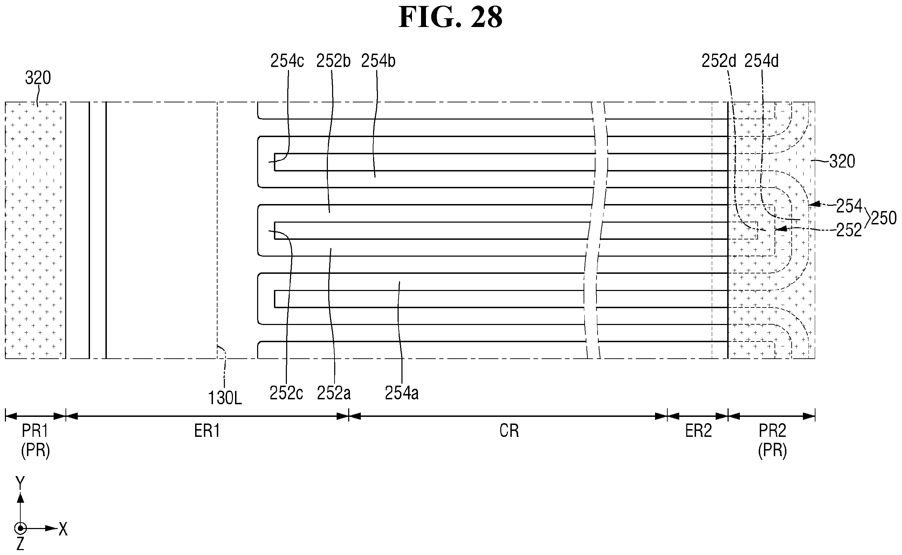

Referring to FIG. 28, in an embodiment, a cell open mask pattern 320 is formed.

The cell open mask pattern 320 exposes the cell region CR, the first boundary region ER1, and the second boundary region ER2. For example, the cell open mask pattern 320 covers the first and second peripheral regions PR1 and PR2. In some embodiments, the cell open mask pattern 320 covers the second inner folding portions 252d and the second outer folding portions 254d.

The cell open mask pattern 320 includes a material with etch selectivity with respect to the first mask film 210L and 215L. In some embodiments, the cell open mask pattern 320 includes a photoresist.

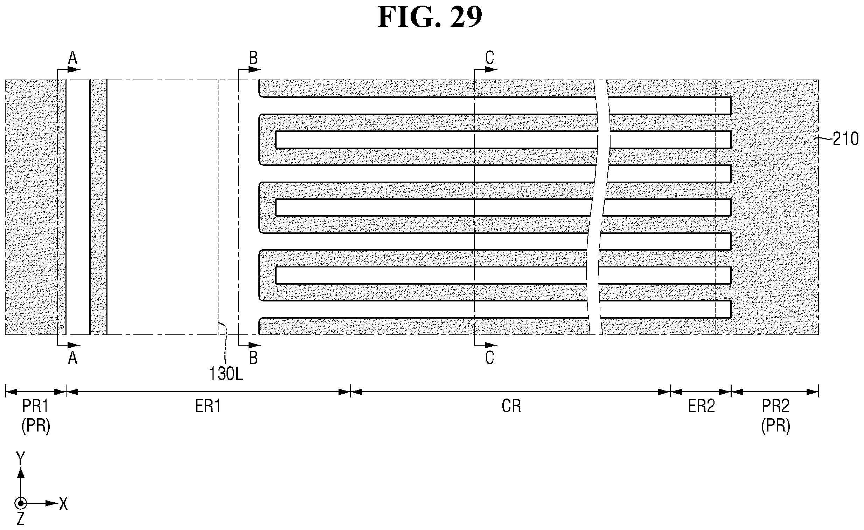

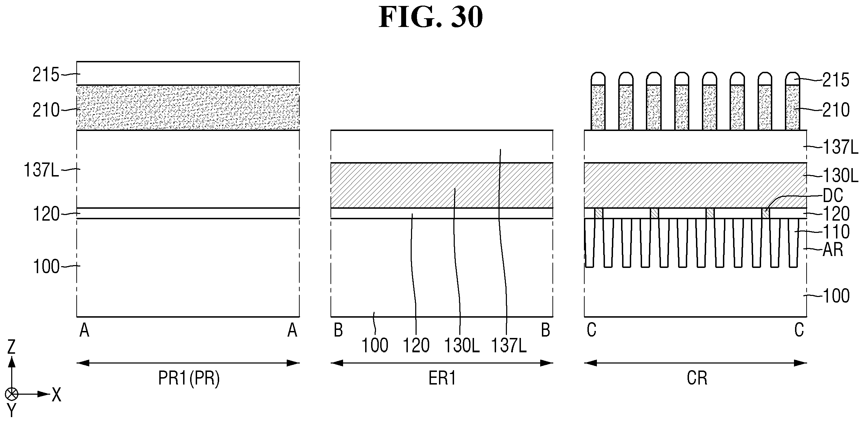

Referring to FIGS. 29 and 30, in an embodiment, a second mask pattern 210 and 215 is formed by patterning the first mask film 210L and 215L using the second spacer patterns 250 and the cell open mask pattern 320 as an etching mask.

For example, an etching process for the first mask film 210L and 215L is performed using the second spacer patterns 250 and the cell open mask pattern 320 as an etching mask. For example, the second mask pattern 210 and 215) is formed from the second spacer patterns 250 and the cell open mask pattern 320. In some embodiments, the second mask pattern 210 and 215 includes a second hard mask pattern 210 and a second antireflection pattern 215. The second hard mask pattern 210 is formed from the second hard mask film 210L, and the second antireflection patterns 215 are formed from the second antireflection film 215L.

In some embodiments, the cell open mask pattern 320 is removed during the formation of the second mask pattern (210 and 215).

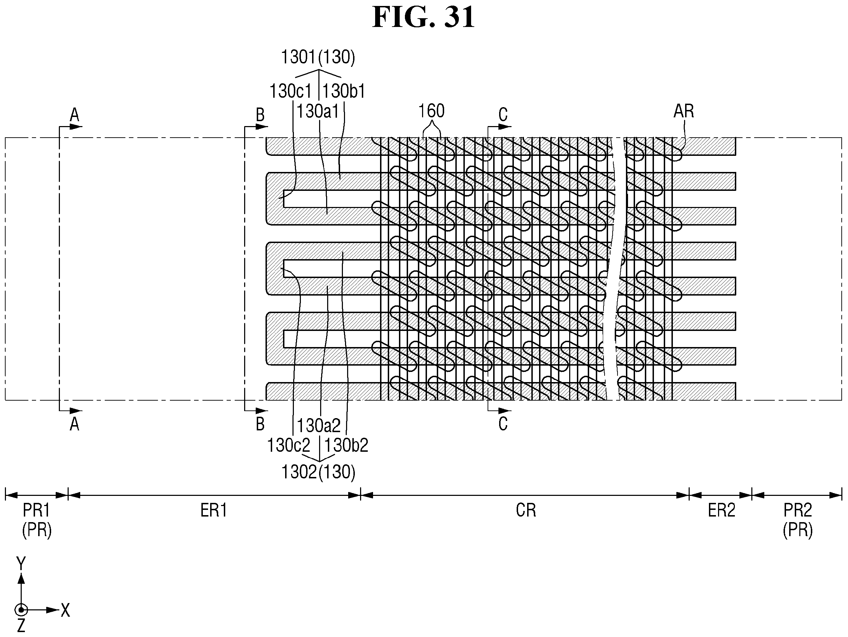

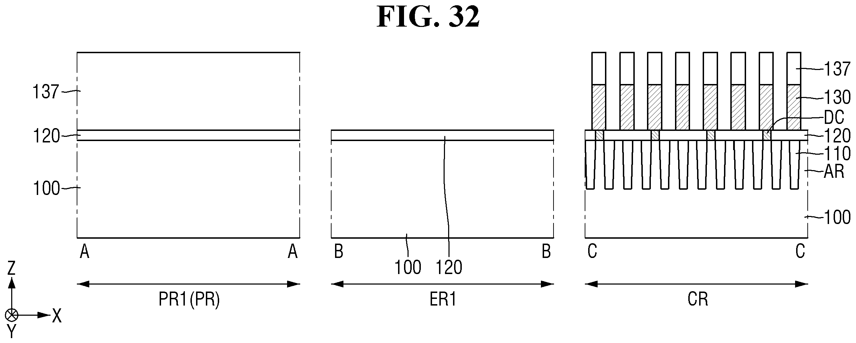

Referring to FIGS. 31 and 32, in an embodiment, target patterns, such as conductive patterns 130, are formed by patterning the target film 130L using the second mask pattern 210 and 215 as an etching mask.

For example, an etching process for the target film 130L and the capping film 137L is performed using the second mask pattern 210 and 215 as an etching mask. As a result of an etching process for the target film 130L and the capping film 137L, the target patterns, such as the conductive patterns 130, are formed from the overlapping areas of the target film 130L and the second mask pattern 210 and 215. In some embodiments, the target film 130L includes a conductive film. In this manner, the conductive patterns 130 of FIG. 2 can be obtained.

The conductive patterns 130 have a "U" shape from a planar perspective. For example, the conductive patterns 130 include a plurality of line patterns 130a1, 130b1, 130a2, and 130b2 that extend in parallel, and a plurality of folding patterns 130c1 and 130c2 that connect the line patterns 130a1, 130b1, 130a2, and 130b2. First line patterns 1301 are formed from the external spacer patterns 254, and second line patterns 1302 are formed from the inner spacer patterns 252.

As semiconductor devices become highly integrated, circuit patterns with folding regions, such as "U"-shaped patterns, may be desired. For example, in semiconductor memory devices, folding bitlines can be used to enhance the storage capacity of unit memory cells. Such circuit patterns can be provided through MPT, such as QPT. Circuit patterns obtained from QPT include inner patterns with a "U" shape on the inside of a mask pattern and outer patterns with a "U" shape on the outside of the mask pattern. However, due to the resolution limit of photolithography, environmental differences can arise between the inner patterns and the outer patterns, leading to defects in the circuit patterns.

In contrast, a method of fabricating a semiconductor device according to some embodiments uses the slit mask pattern 310 that covers the folding regions to eliminate environmental differences between inner patterns and outer patterns. For example, as described above with reference to FIG. 15, the slit mask pattern 310 covers the first folding portions 240c that are located in the first boundary region ER1. For example, as described above with reference to FIG. 21, in subsequent steps, the environmental difference between the folding portions of the inner spacer pattern 252, such as the first inner folding portions 252c, and the folding portions of the outer spacer pattern 254, such as the first outer folding portions 254c, can be eliminated. Moreover, the second line patterns 1302 formed from the inner spacer patterns 252, and the first line patterns 1301 formed from the outer spacer patterns 254, can be provided with a more uniform shape. In this manner, a semiconductor device with increased integration and a method of fabricating the same with increased process margins can be provided.

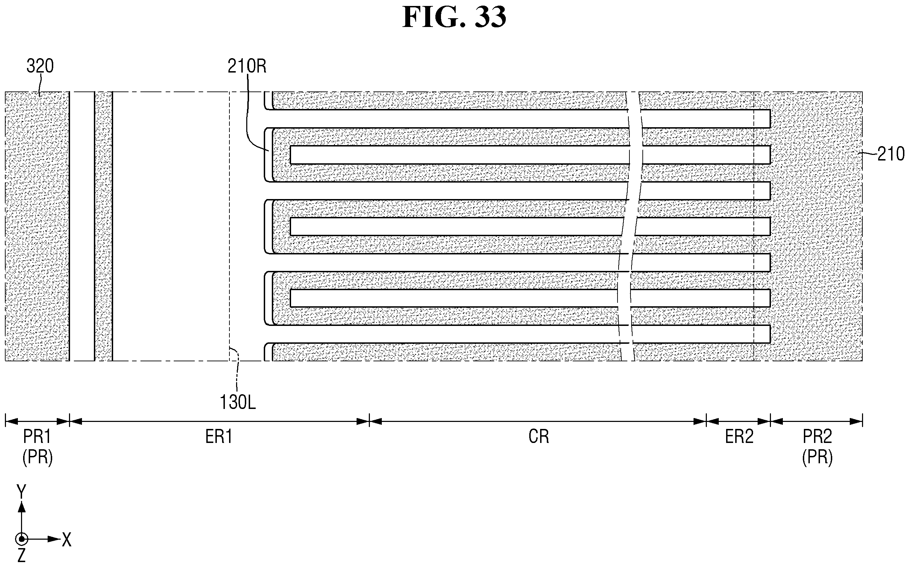

FIG. 33 is a layout view that illustrates an intermediate step of a method of fabricating a semiconductor device according to some embodiments. For example, FIG. 33 illustrates an intermediate step performed after that depicted in FIG. 28. For convenience, descriptions of components described above with reference to FIGS. 1 through 32 will be summarized or omitted.

Referring to FIGS. 28 and 33, in an embodiment, a second mask pattern 210 and 215 is formed by patterning a first mask film 210L and 215L. The formation of the second mask pattern 210 and 215 is performed in the same manner described above with reference to FIGS. 29 and 30, and thus, a detailed description thereof will be omitted.

During the formation of the second mask pattern 210 and 215, residues 210R can be formed on the folding portions of the second mask pattern 210 and 215. The residues 210R include organic materials left from the patterning of the first mask pattern 220 and 225. The residues 210R can be used as an etching mask during the patterning of the target film 130L. In this manner, the conductive patterns 130 of FIG. 5 can be obtained.

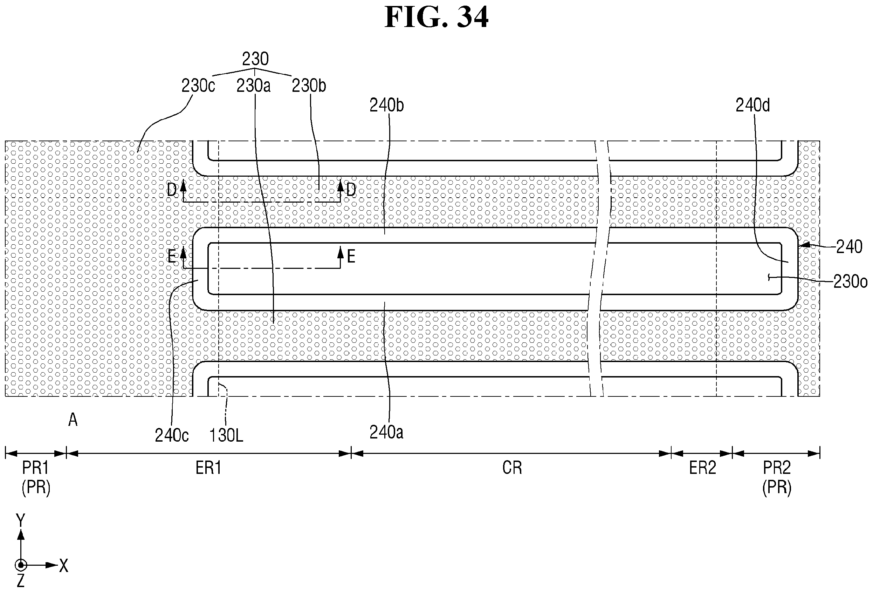

FIGS. 34 through 39 illustrate intermediate steps of a method of fabricating a semiconductor device according to some embodiments. For example, FIG. 34 illustrates an intermediate step performed after that depicted in FIG. 9, and FIGS. 35, 37, and 39 are cross-sectional views taken along lines D-D and E-E of FIGS. 34, 36, and 38, respectively. For convenience, descriptions of components described above with reference to FIGS. 1 through 33 will be summarized or omitted.

Referring to FIGS. 9, 10, 34, and 35, in an embodiment, first spacer patterns 240 are formed by performing an etching process on the first spacer films 240L. The formation of the first spacer patterns 240 can be performed in the same manner described above with reference to FIGS. 11 and 12, and thus, a detailed description thereof will be omitted.

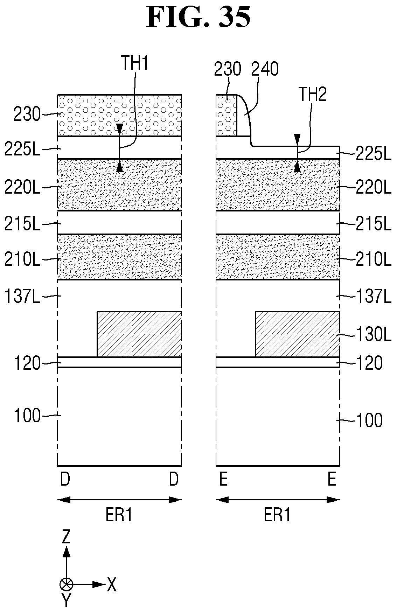

Portions of a second antireflection film 225L are removed by the etching process on the first spacer patterns 240. For example, referring to FIG. 35, a second thickness TH2 of portions of the second antireflection films 225L exposed by an upper hard mask pattern 230 and the first spacer patterns 240 is less than a first thickness TH1 of portions of the second antireflection film 225L protected by the upper hard mask pattern 230 and the first spacer patterns 240.

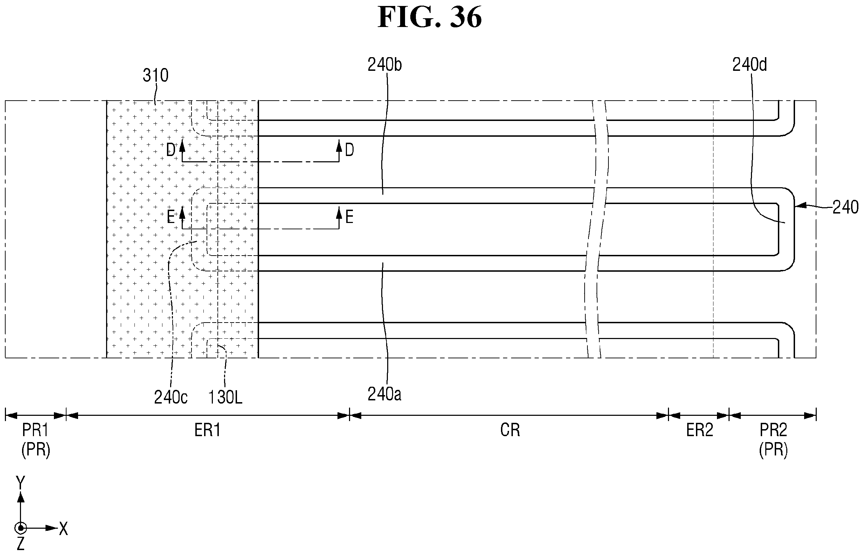

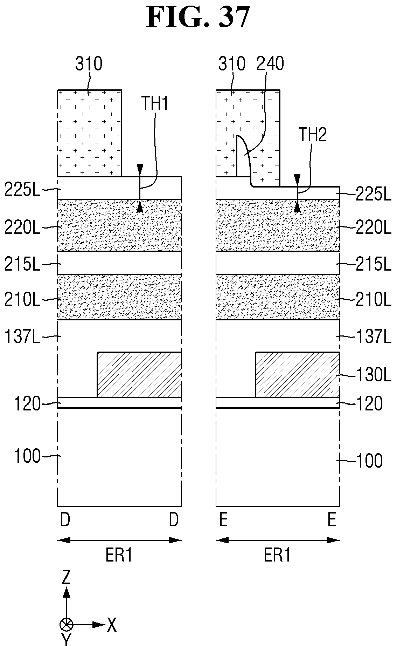

Referring to FIGS. 36 and 37, in an embodiment, an upper mask pattern 230 and 235 is removed, and a slit mask pattern 310 is formed. The removal of the upper mask pattern 230 and 235 and the formation of the slit mask pattern 310 can be performed in the same manners described above with reference to FIGS. 13 through 16, and thus, detailed descriptions thereof will be omitted.

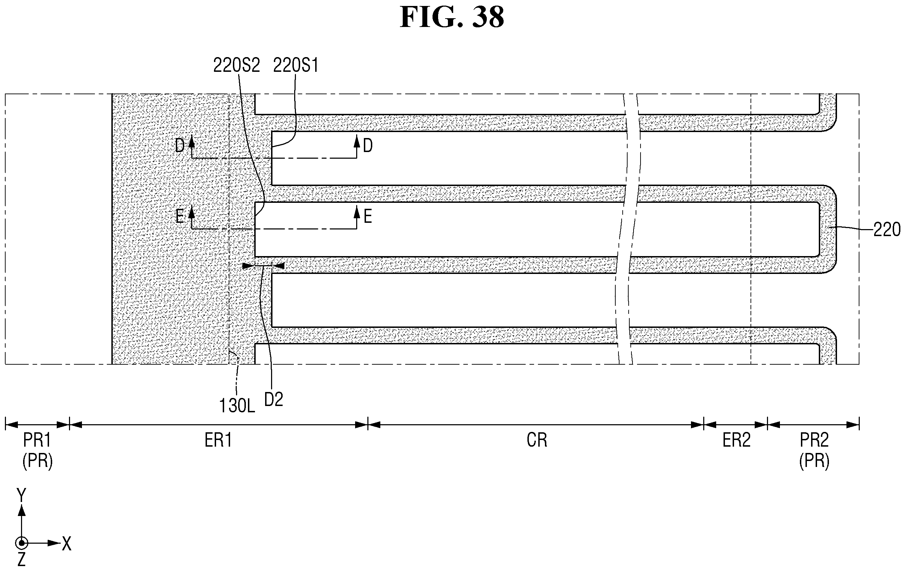

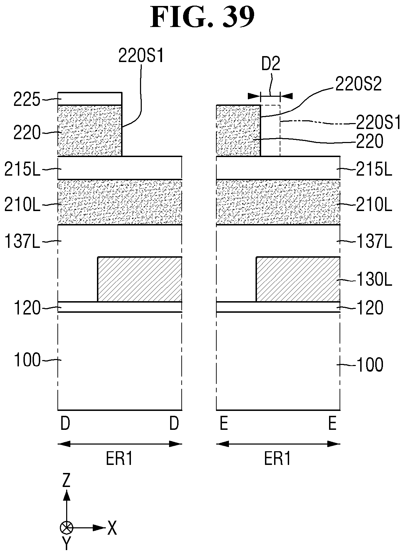

Referring to FIGS. 38 and 39, in an embodiment, a first mask pattern 220 and 225 is formed by patterning a second mask film 220L and 225L. The formation of the first mask pattern 220 and 225 can be performed in the same manner described above with reference to FIGS. 18 and 19, and thus, a detailed description thereof will be omitted.

The first mask pattern 220 and 225 includes first side surfaces 220S1 and second side surfaces 220S2, which alternately protrude in a first direction X. For example, the first side surfaces 220S1 of the first mask pattern 220 and 225 protrude beyond the second side surfaces 220S2 of the first mask pattern 220 and 225 toward a second peripheral region PR2 by a distance D2 because of environmental differences between the regions of the second mask film 220L and 225L where the first side surfaces 220S1 are formed, and the regions of the second mask film 220L and 225L where the second side surfaces 220S2 are formed. For example, the first side surfaces 220S1 are patterned from portions of a second hard mask film 220L below portions of the second antireflection film 225L, which has a relatively larger thickness, such as the first thickness TH1 shown in FIG. 37, whereas the second side surfaces 220S2 are patterned from portions of the second hard mask film 220L below portions of the second antireflection film 225L, which has a relatively smaller thickness, such as the second thickness TH2 shown in FIG. 37. For example, due to the thinness of the second antireflection film 225L, the second side surfaces 220S2 is etched more than the first side surfaces 220S1 by the distance D2 in the first direction X.

Thereafter, the steps described above with reference to FIGS. 19 through 32 are performed. In this manner, the conductive patterns 130 of FIG. 6 can be obtained.

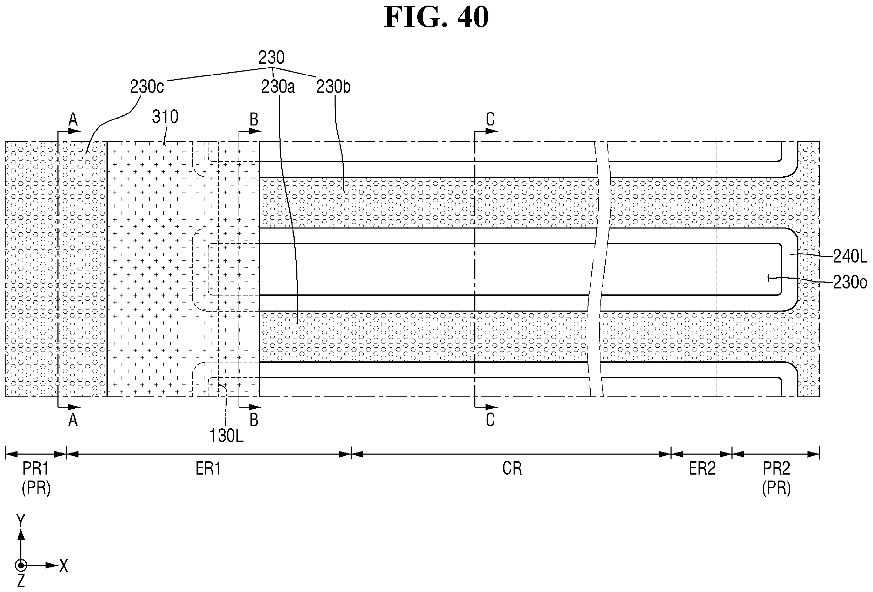

FIGS. 40 through 49 illustrate intermediate steps of a method of fabricating a semiconductor device according to some embodiments. For example, FIG. 40 illustrates an intermediate step performed after that depicted in FIG. 9, and FIGS. 41, 43, 47, and 49 are cross-sectional views taken along lines A-A, B-B, and C-C of FIGS. 40, 42, 46, and 48, respectively. For convenience, description of components described above with reference to FIGS. 1 through 33 will be summarized or omitted.

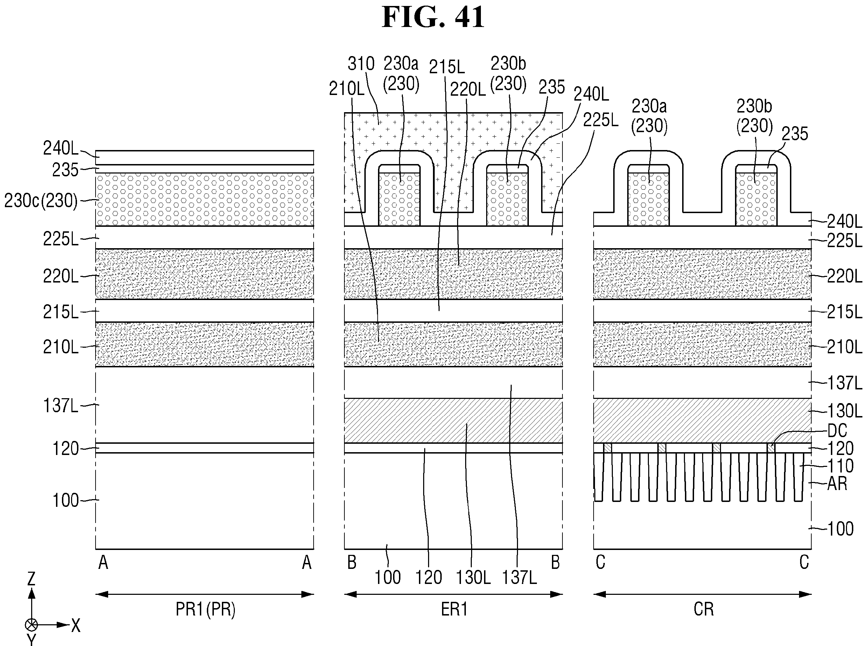

Referring to FIGS. 40 and 41, in an embodiment, a slit mask pattern 310 that covers at least part of a first boundary region ER1 is formed.

The slit mask pattern 310 is formed on a second mask film 220L and 225L) and an upper mask pattern 230 and 235. The slit mask pattern 310 covers portions of first spacer films 240L in the first boundary region ER1. For example, the slit mask pattern 310 covers portions of the first spacer films 240L that are adjacent to an upper mask base 230c.

The slit mask pattern 310 includes a material with etch selectivity with respect to the second mask film 220L and 225L. In some embodiments, the slit mask pattern 310 includes a photoresist.

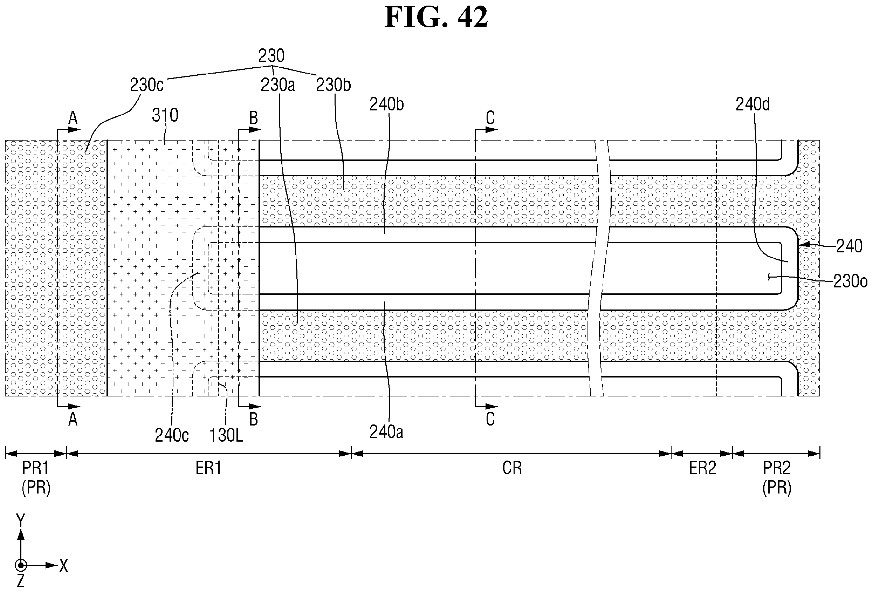

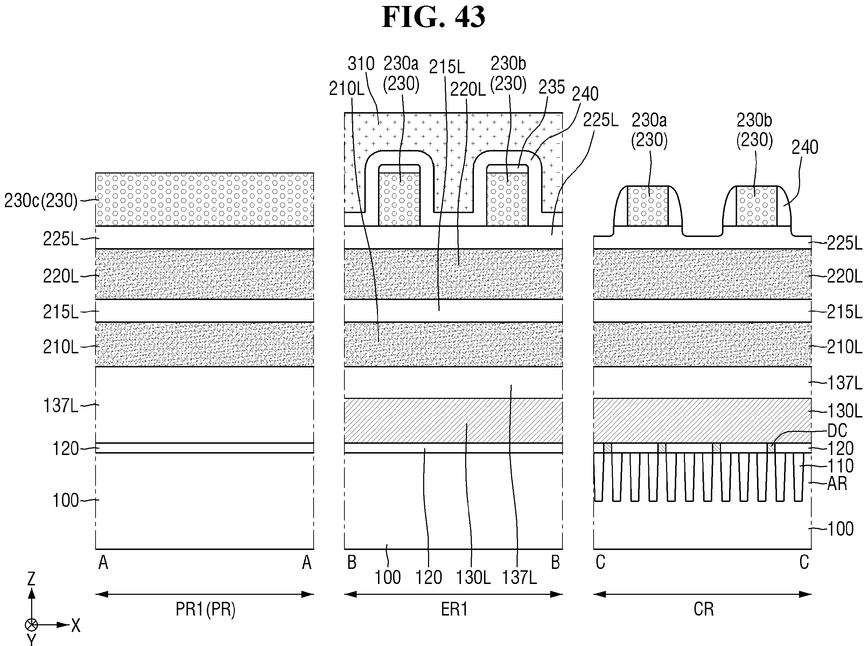

Referring to FIGS. 42 and 43, in an embodiment, first spacer patterns 240 are formed by performing an etching process on the first spacer films 240L. The formation of the first spacer patterns 240 is performed in the same manner described above with reference to FIGS. 11 and 12, and thus, a detailed description thereof will be omitted.

During the formation of the first spacer patterns 240, portions of the first spacer films 240L below the slit mask pattern 310 are not etched. For example, at least some portions of the first spacer patterns 240 in the first boundary region ER1 extend conformally along the top surface of the second mask film 220L and 225L and the side surfaces and top surface of the upper mask pattern 230 and 235.

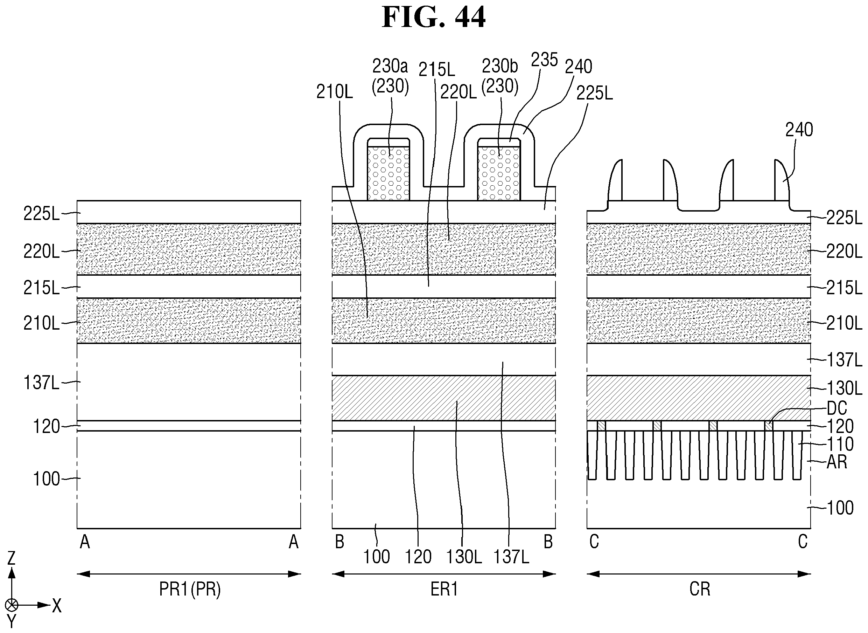

Referring to FIG. 44, in an embodiment, portions of the upper mask pattern 230 and 235 exposed between the first spacer patterns 240 are removed. The removal of the upper mask pattern 230 and 235 is performed in the same manner described above with reference to FIGS. 13 and 14, and thus, a detailed description thereof will be omitted.

Portions of the upper mask pattern 230 and 235 protected by the first spacer patterns 240 are not removed. For example, at least some portions of the upper mask pattern 230 and 235 in the first boundary region ER1 are not removed, but remain.

In some embodiments, the slit mask pattern 310 is removed during the removal of the upper mask pattern (230 and 235).

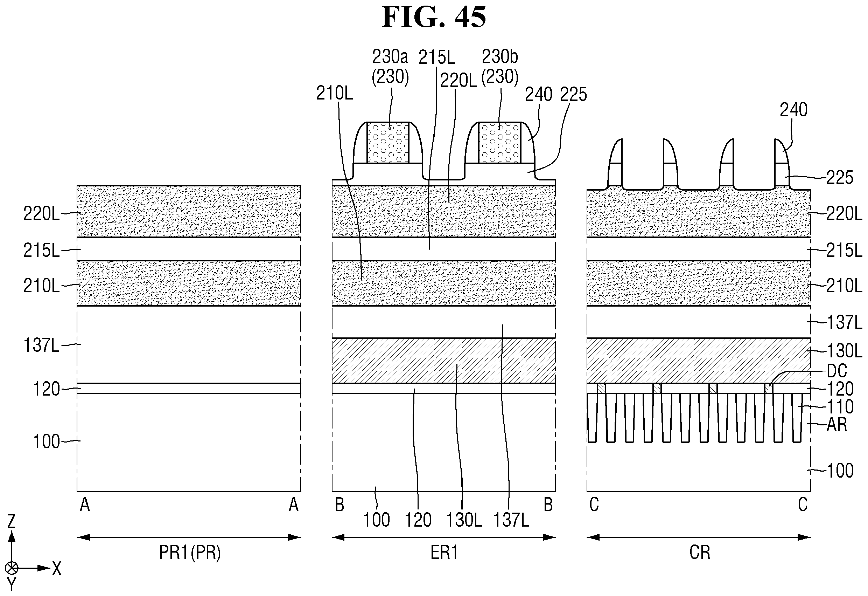

Referring to FIG. 45, in an embodiment, an etching process is performed on the first spacer patterns 240.

As a result of the etching process on the first spacer patterns 240, portions of the first spacer patterns 240 that cover the top surface of the second mask film 220L and 225L and the top surface of the upper mask pattern 230 and 235 are removed.

In some embodiments, a second antireflection film 225L is patterned by the etching process on the first spacer patterns 240, and as a result, first antireflection patterns 225 are formed.

In some embodiments, at least some portions of the first antireflection patterns 225 in the first boundary region ER1 are not completely patterned. For example, at least some portions of the first antireflection patterns 225 in the first boundary region ER1 cover the top surface of a second hard mask film 220L.

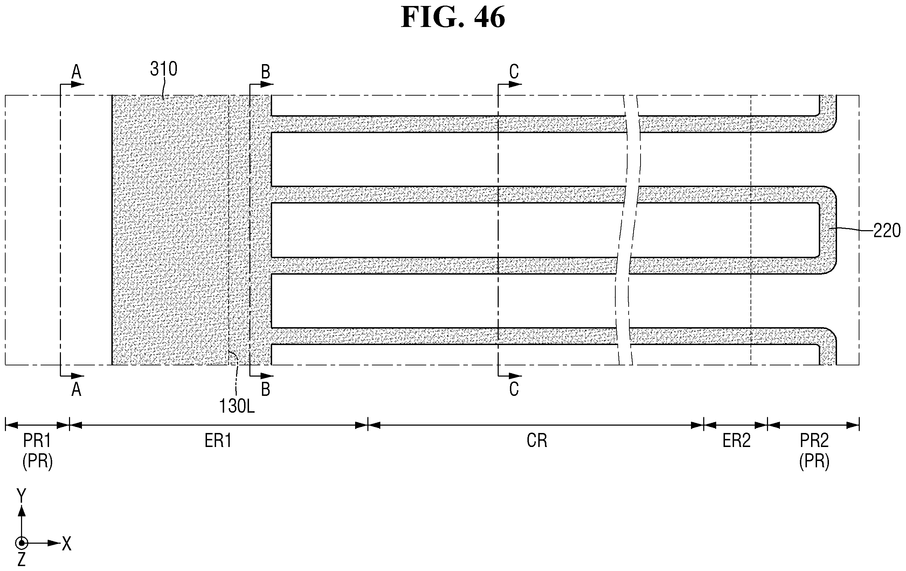

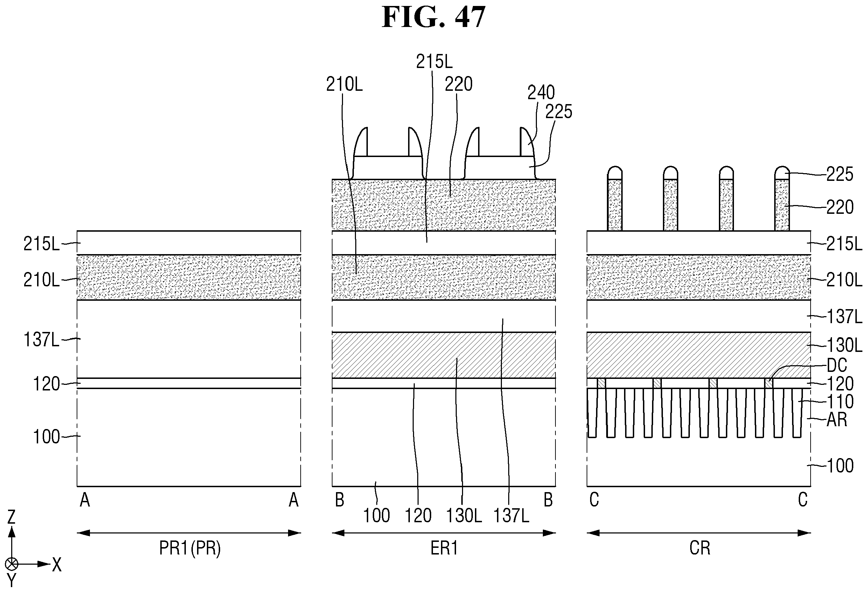

Referring to FIGS. 46 and 47, in an embodiment, a first mask pattern 220 and 225 is formed by patterning the second mask film 220L and 225L using the first spacer patterns 240 as an etching mask.

For example, an etching process on the second hard mask film 220L is performed using the first spacer patterns 240 and the second antireflection patterns 215 as an etching mask. In this manner, the first mask pattern 220 and 225 is formed from the first spacer patterns 240 and the slit mask pattern 310.

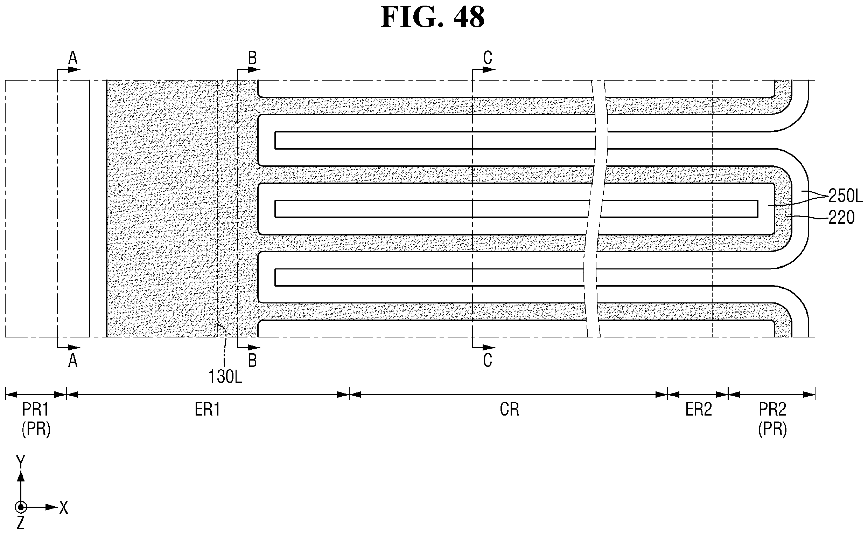

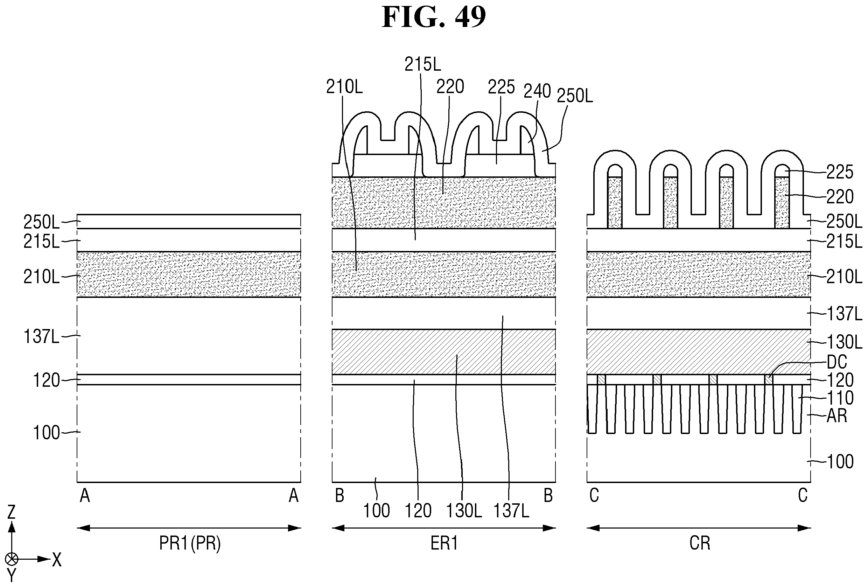

Referring to FIGS. 48 and 49, in an embodiment, second spacer films 250L are formed on the structure depicted in FIGS. 46 and 47. The formation of the second spacer films 250L is performed in the same manner described above with reference to FIGS. 19 and 20, and thus, a detailed description thereof will be omitted.

Thereafter, the steps described above with reference to FIGS. 21 through 32 may be performed. In this manner the conductive patterns 130 of FIG. 2 can be obtained.

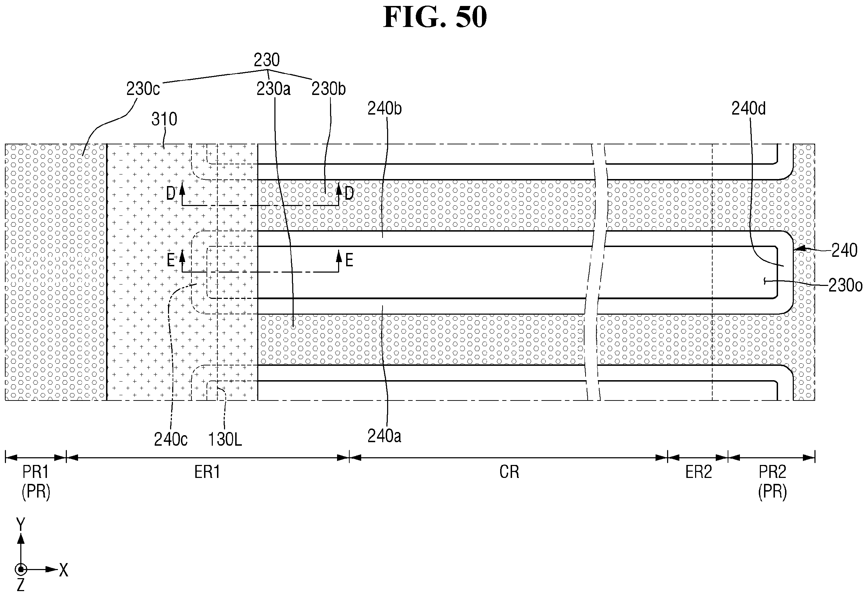

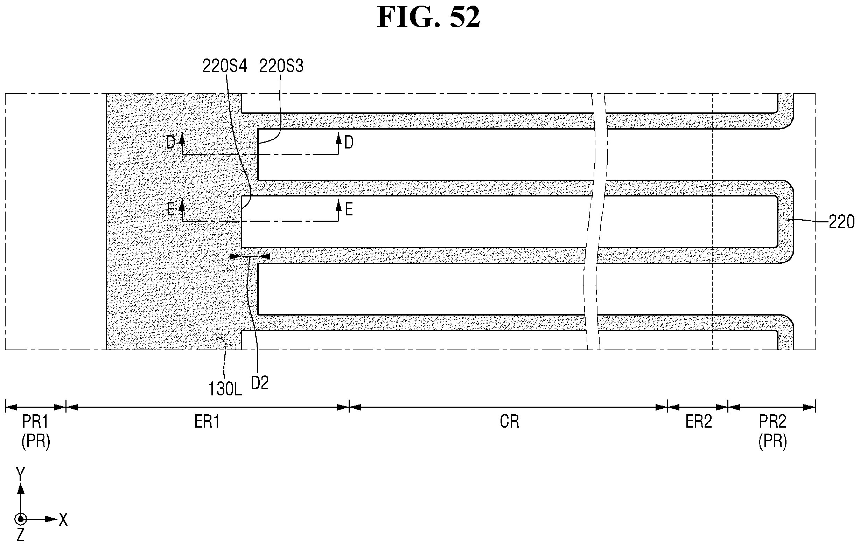

FIGS. 50 through 53 illustrate intermediate steps of a method of fabricating a semiconductor device according to some embodiments. For example, FIG. 50 illustrates an intermediate step performed after that depicted in FIG. 40, and FIGS. 51 and 53 are cross-sectional views taken along lines D-D and E-E of FIGS. 50 and 52, respectively. For convenience, descriptions of components described above with reference to FIGS. 1 through 49 will be summarized or omitted.

Referring to FIGS. 40, 41, 50, and 51, in an embodiment, first spacer patterns 240 are formed by performing an etching process on first spacer films 240L. The formation of the first spacer patterns 240 is performed in the same manner described above with reference to FIGS. 42 and 43, and thus, a detailed description thereof will be omitted.

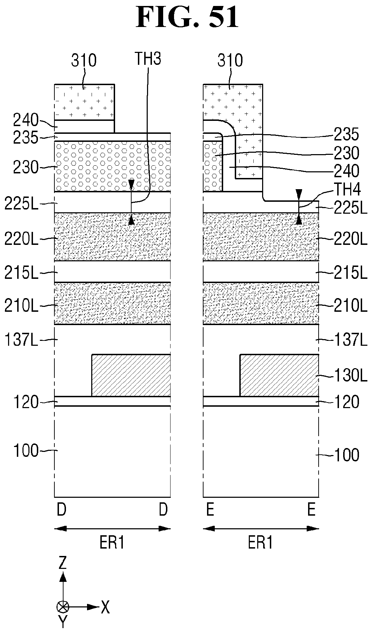

Portions of a second antireflection film 225L are removed by the etching process on the first spacer films 240L. For example, as illustrated in FIG. 51, a fourth thickness TH4 of portions of the second antireflection film 225L exposed by a slit mask pattern 310 is less than a third thickness TH3 of portions of the second antireflection film 225L protected by the slit mask pattern 310.

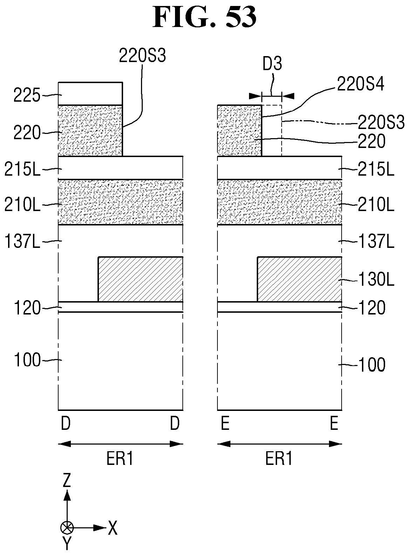

Referring to FIGS. 52 and 53, in an embodiment, a first mask pattern 220 and 225 is formed by patterning the second mask film 220L and 225L. The formation of the first mask pattern 220 and 225 is performed in the same manner described above with reference to FIGS. 44 through 47, and thus, a detailed description thereof will be omitted.

The first mask pattern 220 and 225 includes third side surfaces 220S3 and fourth side surfaces 220S4, which alternately protrude in a first direction X. For example, the third side surfaces 220S3 of the first mask pattern 220 and 225 protrude beyond the fourth side surfaces 220S4 of the first mask pattern 220 and 225 toward a second peripheral region PR2 by a distance D3 because of environmental differences between the regions of the second mask film 220L and 225L where the third side surfaces 220S3 are formed, and the regions of the second mask film 220L and 225L where the fourth side surfaces 220S4 are formed. For example, the third side surfaces 220S3 is patterned from portions of a second hard mask film 220L below portions of the second antireflection film 225L, which has a relatively larger thickness, such as a third thickness TH3 shown in FIG. 51, whereas the fourth side surfaces 220S4 is patterned from portions of the second hard mask film 220L below portions of the second antireflection film 225L, which has a relatively smaller thickness, such as a fourth thickness TH4 shown in FIG. 51. For example, due to the thinness of the second antireflection film 225L, the fourth side surfaces 220S4 are etched more than the third side surfaces 220S3 by the distance D3 in the first direction X.

Thereafter, the steps described above with reference to FIGS. 48, 49, and 21 through 32 are performed. In this manner, the conductive patterns 130 of FIG. 6 can be obtained.

While embodiment of the present inventive concept has been particularly shown and described with reference to drawings thereof, it will be understood by those of ordinary skill in the art that various changes in form and details may be made therein without departing from the spirit and scope of embodiments of the present inventive concept as defined by the following claims. It is therefore desired that the described embodiments be considered in all respects as illustrative and not restrictive, reference being made to the appended claims rather than the foregoing description to indicate the scope of the inventive concept.

## Claims

1. A method of fabricating a semiconductor device, comprising:
providing a substrate that includes a first region and a second region;
sequentially forming a target film, a first mask film, a second mask film, and an upper mask pattern on the substrate;
forming a first spacer pattern that extends along a side surface of the upper mask pattern, wherein the first space pattern includes a first line portion and a second line portion that extend in parallel across the first region and the second region, and a folding portion that is bent from the first line portion and the second line portion on the second region and that connects the first line portion and the second line portion;
forming a slit mask pattern that covers the first spacer pattern on the second region;
forming a first mask pattern by patterning the second mask film using the slit mask pattern and the first spacer pattern as an etching mask;
forming a second spacer pattern that extends along an inner side surface and an outer side surface of the first mask pattern;
forming a second mask pattern by patterning the first mask film using the second spacer pattern as an etching mask; and
forming a plurality of target patterns by patterning the target film using the second mask pattern as an etching mask.

2. The method of claim 1, wherein the target film includes a conductive film.

3. The method of claim 1, wherein each of the target patterns includes a first line pattern and a second line pattern that extend in parallel across the first region and the second region, and a folding pattern that is bent from the first line pattern and the second line pattern and connects the first line pattern and the second line pattern.

4. The method of claim 3, wherein a width of the folding pattern is greater than a width of the first line pattern and a width of the second line pattern.

5. The method of claim 3, wherein a pitch between the first line pattern and the second line pattern is 4 nm to 10 nm.

6. The method of claim 1, further comprising:
removing the upper mask pattern before forming the slit mask pattern.

7. The method of claim 1, further comprising:
removing the upper mask pattern after forming the slit mask pattern.

8. The method of claim 1, wherein the slit mask pattern includes a photoresist.

9. The method of claim 1, wherein
the second spacer pattern includes an inner spacer pattern that extends along the inner side surface of the first mask pattern, and an outer spacer pattern that extends along the outer side surface of the first mask pattern,
the inner spacer pattern includes a first inner line portion and a second inner line portion that extend in parallel, a first inner folding portion that connects a first end of the first inner line portion and a first end of the second inner line portion, and a second inner folding portion that connects a second end of the first inner line portion and a second end of the second inner line portion, and
the outer spacer pattern extends along a circumference of the first inner line portion, a circumference of the second inner line portion, and a circumference of the second inner folding portion, and does not extend along a circumference of the first inner folding portion.

10. The method of claim 1, further comprising:
forming a plurality of active regions within the substrate, wherein the plurality of active regions correspond to the plurality of target patterns;
forming a plurality of direct contacts that connect each of the target patterns with a first portion of each of the active regions;
forming a plurality of capacitor structures on the substrate, wherein the plurality of capacitor structures are connected to a second potion of each of the active regions; and
forming a plurality of gate electrodes on the substrate, wherein the plurality of gate electrodes traverse between the first portion and the second portion of each of the active regions.

11. A method of fabricating a semiconductor device, comprising:
providing a substrate;
sequentially forming a target film, a first mask film, a second mask film, and an upper mask pattern on the substrate;
forming a first spacer pattern that extends along a side surface of the upper mask pattern;
forming a first mask pattern by patterning the second mask film using the first spacer pattern as an etching mask;
forming a second spacer pattern that includes an inner spacer pattern that extends along an inner side surface of the first mask pattern and an outer spacer pattern that extends along an outer side surface of the first mask pattern;
forming a second mask pattern by patterning the first mask film using the second spacer pattern as an etching mask; and
forming a plurality of line patterns by patterning the target film using the second mask pattern as an etching mask,
wherein the inner spacer pattern includes a first inner line portion and a second inner line portion that extend in parallel, a first inner folding portion that connects a first end of the first inner line portion and a first end of the second inner line portion, and a second inner folding portion which connects a second end of the first inner line portion and a second end of the second inner line portion, and
the outer spacer pattern extends along a circumference of the first inner line portion, a circumference of the second inner line portion, and a circumference of the second inner folding portion, and does not extend along a circumference of the first inner folding portion.

12. The method of claim 11, wherein the target film includes a conductive film.

13. The method of claim 11, wherein the target film overlaps the first inner folding portion, and does not overlap the second inner folding portion.

14. The method of claim 11, wherein patterning the target film using the second mask patterns as an etching mask comprises forming a plurality of folding patterns that connect corresponding pairs of adj acent line patterns of the plurality of line patterns.

15. The method of claim 11, wherein the first inner folding portion protrudes beyond the outer spacer pattern.
